(19) **Europäisches Patentamt / European Patent Office / Office européen des brevets**

(11) **EP 4 162 246 B1**

(12) **EUROPÄISCHE PATENTSCHRIFT**

(45) Veröffentlichungstag und Bekanntmachung des Hinweises auf die Patenterteilung:
**03.09.2025 Patentblatt 2025/36**

(21) Anmeldenummer: **21745324.0**

(22) Anmeldetag: **15.07.2021**

(51) Internationale Patentklassifikation (IPC):
*G01L 9/00* (2006.01)  *G01L 19/06* (2006.01)
*B28D 5/00* (2006.01)  *B81C 1/00* (2006.01)
*B23K 26/53* (2014.01)  *B23K 26/00* (2014.01)
*B23K 26/0622* (2014.01)  *B23K 26/08* (2014.01)
*B23K 103/00* (2006.01)  *C03C 3/091* (2006.01)
*C03B 33/02* (2006.01)  *C03C 3/093* (2006.01)
*C03B 33/04* (2006.01)  *C03C 15/00* (2006.01)

(52) Gemeinsame Patentklassifikation (CPC):
**G01L 9/0041; B23K 26/0006; B23K 26/0624; B23K 26/08; B23K 26/53; B28D 5/00; B81C 1/00047; C03B 33/0222; C03B 33/04; C03C 3/091; C03C 3/093; C03C 15/00; G01L 19/0609;** B23K 2103/54; B81B 2201/0264;
(Forts.)

(86) Internationale Anmeldenummer:
**PCT/EP2021/069695**

(87) Internationale Veröffentlichungsnummer:
**WO 2022/013334 (20.01.2022 Gazette 2022/03)**

(54) **GLASWAFER UND GLASELEMENT FÜR DRUCKSENSOREN**

GLASS WAFER AND GLASS ELEMENT FOR PRESSURE SENSORS

TRANCHE DE VERRE ET ÉLÉMENT EN VERRE POUR CAPTEURS DE PRESSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2020 DE 102020118939**

(43) Veröffentlichungstag der Anmeldung:
**12.04.2023 Patentblatt 2023/15**

(73) Patentinhaber: **SCHOTT AG**
**55122 Mainz (DE)**

(72) Erfinder:
• **PEUCHERT, Ulrich**
**55294 Bodenheim (DE)**
• **BLEZINGER, Martin**
**55118 Mainz (DE)**

• **UTZ, Thomas**
**64287 Darmstadt (DE)**
• **BREITBACH, Christian**
**64285 Darmstadt (DE)**
• **JOTZ, Matthias**
**55122 Mainz (DE)**
• **LIEBSCH, Sören**
**99090 Erfurt (DE)**

(74) Vertreter: **Schott Corporate IP**
**Hattenbergstraße 10**
**55122 Mainz (DE)**

(56) Entgegenhaltungen:
JP-A- H09 126 924    US-A1- 2005 172 724
US-A1- 2018 215 647

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

(52) Gemeinsame Patentklassifikation (CPC): (Forts.)
B81C 2201/0143

## EP 4 162 246 B1

**Beschreibung**

<u>Gebiet der Erfindung</u>

Die Erfindung betrifft allgemein einen Glaswafer zur Herstellung von Glaselementen für die Verwendung in Drucksensoren, beispielsweise in piezoresistiven oder kapazitiven Drucksensoren, vorzugsweise in piezoresistiven Drucksensoren, und ein Glaselement für die Verwendung in Drucksensoren, sowie ein Verfahren zur Herstellung eines solchen Glaselements und eines Glaswafers. Ein weiterer Aspekt betrifft einen Drucksensor, der ein solches Glaselement umfasst oder mittels eines solchen Glaselements erhältlich ist.

<u>Hintergrund der Erfindung</u>

Mikroelektromechanische (oder MEMS-) Drucksensoren umfassen eine dünne Membran aus Silizium, die durch Druck elastisch verformbar ist. Diese Siliziummembran ist in der Regel auf einem Sockel aus einem Isolator oder einem halbleitenden Material, beispielsweise Silizium, aufgebracht. Der Sockel weist eine Öffnung auf, durch welche ein Fluid, wie beispielsweise ein Gas oder eine Flüssigkeit, in die Messkavität des Drucksensors eindringen kann. Auf die Membran wirken dabei von beiden Seiten Drücke ein, ein Referenzdruck auf der einen Seite sowie ein variabler Druck auf der der Messkavität zugewandten Seite der Membran, wobei der Referenzdruck sowohl festgelegt als auch variabel sein kann. Unterscheiden sich die Drücke auf den beiden Seiten der Membran voneinander, kommt es zu einer Verformung der Membran. In die Membran eingebracht sind Messwiderstände, die bei Verformung ihren Widerstand ändern (sogenannte piezoresisitive Widerstände). Diese sind elektrisch in Form einer sogenannten Wheatstoneschen Brückenschaltung angeordnet. Bei einer Verformung der Membran kommt es zu einer Änderung der elektrischen Spannung der Brückenschaltung. Diese messbare Änderung der Brückenspannung ist näherungsweise proportional zum Druckunterschied. Alternativ können Druckunterschiede auch kapazitiv gemessen werden. Hierbei sind nicht Widerstände im Silizium eingebracht, sondern mikromechanische Strukturen zur Messung von Kapazitäten, sprich Kondensator-Funktionalitäten.

Als Sockelmaterial für einen solchen Drucksensor kann beispielsweise ein isolierendes Material wie Glas oder ein halbleitendes Material wie Silizium verwendet werden. Zur Reduktion der Bauteilgröße werden dabei nach Möglichkeit dünne Sockelelemente verwendet, die eine Dicke von weniger als 1 mm aufweisen, beispielsweise im Bereich zwischen 200 μm und 900 μm, insbesondere von beispielsweise 800 μm oder 400 μm. Zur Gewährleistung einer möglichst guten thermischen Entkopplung des MEMS-Bauteils zum Trägermaterial können aber auch dickere Sockel erforderlich sein. Diese können bis 3,5 mm dick sein.

Die genaue Ausgestaltung der in das Sockelmaterial eingebrachten Öffnung ist variabel. In der Regel weisen diese Öffnungen einen runden Querschnitt auf, wobei die Größe der Querschnittsöffnung über die Dicke des Sockelmaterials variieren kann. Beispielsweise ist es möglich, dass die Querschnittsöffnung eine kegelstumpfartige Form aufweist, also die Wände der Öffnung bei runder Querschnittsform zueinander geneigt sind. Auch pyramidenstumpfartige Formen der Öffnung sind bekannt.

In der japanischen Patentanmeldung JP S57-128074 A ist ein Drucksensor beschrieben, bei welchem das Sockelmaterial aus einem Siliziumeinkristall einer bestimmten kristallographischen Orientierung ausgebildet ist. Die Öffnung im Sockel wird durch anisotropes Ätzen des Einkristalls erhalten. Je nach der genauen Orientierung des einkristallinen Sockelmaterials ist es möglich, unterschiedliche Geometrien der Öffnung zu erhalten, so dass neben Öffnungen mit rundem Querschnitt auch Öffnungen mit eckiger Querschnittsfläche möglich sind.

In der US-amerikanischen Patentanmeldung US 2011/0000304 A1 wird ein Drucksensor umfassend einen Glassockel beschrieben, wobei die Öffnung im Glassockel unterschiedliche Durchmesser aufweist, und zwar in der Form, dass der Durchmesser der Öffnung in Richtung zur Siliziummembran größer ist als der Durchmesser der Öffnung, welcher einem metallischen Sockel zugewandt ist. Ein Verfahren, wie in dem Glasmaterial unterschiedliche Durchmesser erzeugt werden, ist nicht beschrieben.

Die US-amerikanische Patentanmeldung US 2006/0288793 A1 beschreibt einen Drucksensor umfassend ein Druckübertragungsgel, bei welchem im vom Drucksensor umfassten Glassockel ein bestimmtes Verhältnis zwischen der Dicke des Glassockels und der in den Glassockel eingebrachten Öffnung vorliegt. Dies dient dazu, Verformungen der Siliziummembran durch das Gel, welche insbesondere durch die Ausdehnung des Gels bei Temperaturschwankungen hervorgerufen werden können, vorzubeugen, indem ein ausreichender Durchmesser der Öffnung vorliegt und gleichzeitig eine nur geringe Dicke des Glassockels erhalten wird.

Die US-amerikanische Patentanmeldung US 2005/01 72724 A1 beschreibt einen Drucksensor mit einem Glassockel. Der Glassockel umfasst eine Öffnung, welche eine über die Dicke des Glassockels variierende Größe aufweist. Beispielsweise kann die Öffnung die Form eines Kegelstumpfs oder eines Pyramidenstumpfs aufweisen. Die der Drucksensormembran abgewandte Seite des Glassockels weist dabei eine kleinere Größe der Öffnung auf als die Öffnung auf der Seite des Glassockels, die zur Siliziummembran hin orientiert ist. Dies hat den Grund, dass auf diese Weise der Eintrag von Verunreinigung in die Messkavität und somit eine Verfälschung der Druckmessung verhindert oder

3

zumindest minimiert werden soll. Die Öffnung kann beispielsweise durch USSL (Ultraschallschwingläppen) in den Glassockel eingebracht werden.

Eine über die Dicke des Glassockels variierende Größe der Öffnung im Glassockel beschreibt auch die japanische Patentanmeldung JP H09-126924 A. Die Öffnung wird dabei durch einen Ätzprozess erzeugt. Auf der der Siliziummembran abgewandten Seite des Glassockels ist die Größe der Öffnung größer als auf der der Siliziummembran zugewandten Seite des Glassockels. Dies soll dazu dienen, dass die mechanische Stabilität der Öffnung im Glassockel verbessert wird und es nicht zu einem Ausbrechen des Randes der Öffnung im Glassockel auf der der Siliziummembran abgewandten Seite kommt.

Das US-amerikanische Patent US 9 470 593 B2 beschreibt einen Drucksensor, bei welchem die Abdeckung oder Kappe aus Glas ausgebildet sein kann und eine Öffnung aufweist, wobei die Öffnung eine beliebige Form und Größe aufweisen kann, sodass Fluid durch die Öffnung hindurch zum Wafer gelangen kann.

Weiterhin beschreibt die US-amerikanische Patentanmeldung US 2009/0096040 A1 einen Sensor mit einer optimierten Sensorgeometrie.

Aus dem Stand der Technik sind mithin sehr unterschiedliche Ausgestaltungen von Sockeln für Drucksensoranwendungen bekannt. Dabei hat sich gezeigt, dass die genaue Ausgestaltung der Öffnung im Sockel einen wesentlichen Einfluss auf die mechanische Stabilität und/oder die Verlässlichkeit des Drucksensors hat. Beispielsweise spielt sowohl die Größe der Öffnung, der Neigungswinkel der Seitenwände bzw. Seitenfläche und auch die Ausgestaltung der Oberfläche dieser Seitenwände bzw. der Seitenfläche eine besondere Rolle, beispielsweise hinsichtlich der Benetzbarkeit und/oder Beschichtbarkeit. Eine gezielte Einstellung der Oberflächeneigenschaften der Seitenfläche bzw. Seitenwände des Glassockels, beispielsweise in einem vorzugsweise hoch reproduzierbaren Prozess, vorzugsweise in Kombination mit der geometrischen Ausgestaltung der Öffnung in der Wafer- oder Sheetebene, beispielsweise in der Form, dass wenigstens eine Kante der Öffnung wenigstens abschnittsweise gerade ausgebildet ist, kann hier einen entscheidenden Beitrag zur Verbesserung bekannter Drucksensoren liefern.

Es besteht damit ein Bedarf an Glaselementen bzw. Glaswafern für die Herstellung von Glaselementen für Drucksensoren, die bekannte Schwächen des Standes der Technik zumindest mindern.

Aufgabe der Erfindung

Der vorliegenden Erfindung liegt damit die Aufgabe zugrunde, einen Glaswafer bzw. ein Glaselement für die Anwendung in einem Drucksensor bereitzustellen, welches die mechanische Stabilität und/oder die Verlässlichkeit eines Drucksensors weiter verbessert. Weitere Aspekte betreffen ein Verfahren zur Herstellung eines Glaselements sowie einen Drucksensor, welcher ein solches Glaselement umfasst.

Die Verbesserung der Stabilität und/oder der Verlässlichkeit eines Drucksensors kann hier sowohl die Verbesserung der mechanischen Stabilität und mithin beispielsweise der Lebensdauer eines Drucksensors sein, umfasst aber allgemein auch andere Aspekte, beispielsweise die Homogenität und/oder Stabilität eines vom Sensor generierten Signals.

Zusammenfassung der Erfindung

Die Aufgabe der Erfindung wird gelöst durch den Gegenstand der unabhängigen Ansprüche.

Bevorzugte und spezielle Ausführungsformen finden sich in den abhängigen Ansprüchen und der weiteren Offenbarung der vorliegenden Schrift.

Die vorliegende Offenbarung betrifft damit einen Glaswafer zur Herstellung eines rahmenförmigen Glaselements für die Anwendung in Drucksensoren, wie beispielsweise piezoresistiven oder kapazitiven Drucksensoren, vorzugsweise in piezoresistiven Drucksensoren, umfassend ein scheibenförmiges Glassubstrat sowie wenigstens eine Öffnung, die von einer Oberfläche des scheibenförmigen Glassubstrats zur anderen Oberfläche des scheibenförmigen Glassubstrats reicht, wobei die Öffnung einen Querschnitt mit einer Querschnittsfläche aufweist, wobei die Querschnittsfläche durch wenigstens einen geraden Abschnitt, vorzugsweise mit einer Mindestlänge von mindestens 10 μm, bevorzugt mindestens 20 μm und besonders bevorzugt mindestens 100 μm, begrenzt ist, wobei die Öffnung eine Seitenfläche aufweist, die eine Oberfläche aufweist, welche gekennzeichnet ist durch eine Skewness Ssk, bestimmt nach der folgenden Formel

$$(1) \qquad \mathrm{Ssk} = \frac{1}{S_q^3} \left[ \frac{1}{A} \iint_A \left( Z(x,y)^3 \right) dx dy \right]$$

von ungleich 0, wobei der Betrag der Skewness Ssk mindestens 0,001 ist und höchstens 5, wobei besonders bevorzugt die Skewness in einem ebenen Bereich der Seitenfläche bestimmt wird, vorzugsweise in einem Bereich, welcher dem geraden Abschnitt entspricht.

In der obigen Formel bezeichnet $S_q$ die mittlere quadratische Rauigkeit der Oberfläche, beziehungsweise den RMS-Wert. A bezeichnet die Fläche des Integrationsgebietes, für welches die Skewness bestimmt wird. Z(x,y) bezeichnet den jeweiligen Höhenwert des Oberflächenprofils an den Koordinaten x,y. Dieser Höhenwert wird relativ zum arithmetischen Mittelwert der Höhenwerte des Oberflächenprofils angegeben. Liegt ein Punkt des Oberflächenprofils also höher als der Mittelwert, ist der zugehörige Wert Z(x,y) positiv, liegt der Punkt unterhalb des Mittelwerts, ist Z(x,y) negativ. Bei einer praktischen Messung an einer Oberfläche kann anstelle einer Berechnung des Integrals vielmehr eine Bestimmung des Oberflächenprofils an diskreten Punkten vorgenommen werden. Das Integral kann dann durch eine Summe und die Fläche durch die Anzahl der Summanden, beziehungsweise Messpunkte ersetzt werden. Für die Ssk ergibt sich dann:

$$(2) \qquad Ssk = \frac{1}{m} \sum_{i=1}^{m} \frac{Z(x,y)^3}{S_q{}^3}$$

Die Skewness wird vorzugsweise bestimmt mittels Weißlichtinterferometrie (abgekürzt WLi). Eine solche Messung kann beispielsweise mit einem Weißlichtinterferometer der Firma Zygo, beispielsweise dem Interferometer ZYGO NewView durchgeführt werden. Die Daten werden mit der Software ZYGO Mx[TN] unter entsprechenden Vergrößerungen (20fache Vergrößerung mittels Objektiv sowie 0,5facher Zoom) aufgenommen und ausgewertet. Um die Genauigkeit der Auswertungen zu erhöhen, wird mit der Software eine Eingrenzung der Auswertungsfläche (sogenannte Maske) vorgenommen, mit der die unmessbaren Flächen ausgegrenzt werden können. Hier wird je nach Bedarf ein rechteckiger Messbereich mit den Abmessungen 740 $\mu$m * 320 $\mu$m oder 740 $\mu$m * 520 $\mu$m ausgewählt. Die Werte der Ssk werden dabei bestimmt nach der folgenden Formel, der oben angegebenen Formel (1):

$$Ssk = \frac{1}{S_q^3} \left[ \frac{1}{A} \iint_A (Z(x,y)^3) \, dx dy \right]$$

Der Wert $S_q$ kann gemäß folgender Gleichung berechnet werden:

$$(3) \qquad S_q = \sqrt{\frac{1}{A} \iint_A Z^2(x,y) dx dy}$$

Es handelt sich dabei also um den quadratischen Mittenwert der Höhe. Auch bei dessen Ermittlung kann anstelle einer Integration eine Berechnung mit einer Anzahl diskreter Messpunkte mittels einer Summe erfolgen:

$$(4) \qquad S_q = \sqrt{\frac{1}{m} \sum_{i=1}^{m} Z(x,y)^2}$$

Bevorzugt ist der Betrag der Skewness mindestens 0,002, mehr bevorzugt mindestens 0,003, besonders bevorzugt mindestens 0,004 und ganz besonders bevorzugt mindestens 0,01.

Gemäß einer bevorzugten Ausführungsform ist der Betrag der Skewness höchstens 2,0, besonders bevorzugt höchstens 1,5.

Insbesondere kann der Betrag der Skewness liegen zwischen 0,003 und 5, bevorzugt zwischen 0,004 und 2,0, besonders bevorzugt zwischen 0,01 und 1,5.

Insbesondere kann die Skewness gemäß einer Ausführungsform größer als 0 sein. In diesem Fall ist die Oberfläche als eine überwiegend von Erhöhungen gekennzeichnete Oberfläche ausgebildet. Die Oberfläche mit aneinander gereihten Aufwölbungen kann das Vorbeiströmen des Fluids begünstigen, da durch die Kerbenkonfiguration die Einstellung einer turbulenten Grenzschicht an der Lochwandung erreicht wird. Diese wirkt wie eine lokale Erhöhung der Fluidviskosität und begünstigt die angrenzenden laminaren Strömungen.

In diesem Fall ist die Skewness mindestens 0,001 und höchstens 5. Bevorzugt beträgt dabei die Skewness mindestens 0,002, insbesondere mindestens 0,003, vorzugsweise mindestens 0,004 und ganz besonders bevorzugt mindestens 0,01. Weiterhin bevorzugt beträgt die Skewness höchstens 2,0, bevorzugt höchstens 1,5.

Bevorzugte Bereiche für die Skewness liegen hier zwischen mindestens 0,003 und höchstens 5, insbesondere mindestens 0,004 und höchstens 2,0, besonders bevorzugt zwischen 0,01 und 1,5.

Gemäß einer weiteren Ausführungsform kann die Skewness kleiner als 0 sein. In diesem Fall ist die Oberfläche überwiegend von Vertiefungen gekennzeichnet. In diesem Fall ist die Oberfläche frei von schmalen Vertiefungen, welche auch als Kerben bezeichnet werden können. Dadurch ergibt sich insbesondere im Belastungsfall unter Beaufschlagung von Druck, eine reduzierte Kerbwirkung, was die Bauteilfestigkeit erhöht.

In diesem Fall ist die Skewness höchstens -0,001 und weiterhin mindestens -5. Bevorzugt beträgt dabei die Skewness höchstens -0,002, insbesondere höchstens -0,003, vorzugsweise höchstens -0,004 und ganz besonders bevorzugt höchstens -0,01. Weiterhin bevorzugt beträgt die Skewness mindestens -2, bevorzugt mindestens -1,5. Bevorzugte Bereiche für die Skewness liegen hier zwischen höchstens -0,003 und mindestens -5, insbesondere höchstens -0,004 und mindestens -2,0, besonders bevorzugt zwischen -0,01 und -1,5.

Im Rahmen der vorliegenden Offenbarung gelten die folgenden Begriffsbestimmungen:

Unter einem Glassubstrat wird im Rahmen der vorliegenden Offenbarung ein Erzeugnis aus oder umfassend ein glasiges Material verstanden. Unter einem glasigen Material wird allgemein ein anorganisches, amorphes Material verstanden, welches insbesondere in einem Schmelzprozess aus einem Gemenge erschmolzen wird. An den Schmelzprozess kann sich noch ein sogenannter Heißformgebungsprozess anschließen, sodass beispielsweise eine Platte oder Scheibe aus oder umfassend ein glasiges Material erhalten wird (also beispielsweise eine Glasplatte oder Glasscheibe). Dem Fachmann bekannte Heißformgebungsprozesse umfassen beispielsweise Ziehen, Walzen oder Floaten. Ein Glassubstrat im Sinne der vorliegenden Offenbarung kann also beispielsweise als Glasscheibe oder Glasplatte ausgebildet sein. Insbesondere kann im Rahmen der vorliegenden Offenbarung das glasige Material ein sogenanntes Borosilikatglas sein oder ein solches umfassen.

Unter einem ebenen Bereich einer Oberfläche oder allgemeiner Fläche wird hierbei ein Bereich einer Oberfläche oder allgemeiner Fläche verstanden, welcher nicht gekrümmt ist. Der ebene Bereich kann dabei aber insbesondere so ausgestaltet sein, dass einer Rauigkeit aufweist. Dies bedeutet, dass ein ebener Bereich im Sinne der vorliegenden Offenbarung nicht als ideal plan oder glatt verstanden wird. Vielmehr kann ein ebener Bereich im Sinne der vorliegenden Offenbarung insbesondere ein Bereich sein, welcher von mindestens einem geraden Abschnitt begrenzt ist.

Das Glassubstrat ist vorzugsweise transparent ausgebildet, wobei Transparenz hier bezogen wird auf elektromagnetische Strahlung im Wellenlängenbereich von 380 nm bis 780 nm, also im Bereich des sichtbaren Lichts.

Das Glassubstrat kann insbesondere scheibenförmig ausgebildet sein. Darunter wird verstanden, dass die laterale Abmessung des Glassubstrats in einer ersten Richtung eines kartesischen Koordinatensystems (die auch als die Dicke des Glaselements verstanden werden kann) höchstens ein Fünftel der lateralen Abmessungen in den beiden weiteren, zur ersten Richtung senkrechten Richtungen des kartesischen Koordinatensystems (die auch als Länge und Breite des Glaselements verstanden werden können). Mit anderen Worten beträgt die Dicke des Glassubstrats höchstens ein Fünftel von Länge bzw. Breite. Ausführungsformen, bei welchen die Länge und Breite des Glassubstrats deutlich mehr als das Fünffache der Dicke betragen, sind ebenfalls möglich. In diesem Falle ist das Glassubstrat als sehr lange und breite, dünne Scheibe ausgebildet, beispielsweise als Dünnglasscheibe oder Dünnglasband. Ein Band ist im Rahmen der vorliegenden Schrift ein Formkörper, dessen Länge deutlich größer ist, beispielsweise eine Größenordnung größer, als die Breite. Liegen Länge und Breite in derselben Größenordnung, spricht man in der Regel von einer Scheibe. Ist das Glassubstrat kreisförmig ausgebildet, tritt an die Stelle von Länge und Breite der Durchmesser des Glassubstrats.

Die Angabe der lateralen Abmessungen bezieht sich hierbei auf den Abstand, welchen die das Glassubstrat begrenzenden Oberflächen voneinander haben. Mit anderen Worten ist das Glassubstrat ein Formkörper aus oder umfassend ein glasiges Material. Sofern im Rahmen der vorliegenden Offenbarung von Oberflächen des Glassubstrats sowie entsprechend von Oberflächen eines Glaswafers oder eines Glaselements gesprochen wird, handelt es sich dabei, sofern dies nicht ausdrücklich anders ausgeführt ist, um die Flächen, welche zusammen mehr als 50 % der gesamten Oberfläche des Formkörpers ausmachen. Bei einer scheibenförmigen Ausbildung des Glassubstrats sind diese Oberflächen, welche auch als Hauptflächen bezeichnet werden können, die durch die Länge und Breite des Glassubstrats definierten Flächen bzw. für den Fall einer kreisförmigen bzw. elliptischen Ausbildung des Glaselements die beiden Kreisflächen bzw. die beiden Ellipsen. Die Hauptflächen des Glassubstrats können auch als Seiten bezeichnet werden. Je nach genauer Anordnung des Glassubstrats bzw. in entsprechender Weise auch des Glaswafers oder des Glaselements können diese beispielsweise bei waagrechter Lagerung des Glassubstrats (oder Wafers oder Glaselements) auch als Oberseite und Unterseite oder bei senkrechter Lagerung auch als Vorderseite und Rückseite bezeichnet werden.

In der Regel sind die Oberflächen des Glassubstrats im Wesentlichen parallel zueinander angeordnet, d.h. das Glassubstrat kann in geometrischer Hinsicht auch als dünner, ggf. langgestreckter Quader oder als dünner Kreiszylinder oder allgemein als dünnes Prisma mit beliebiger Grundfläche beschrieben werden. Unter einer im Wesentlichen parallelen Anordnung der Oberflächen wird verstanden, dass die Oberflächen miteinander einen Winkel von höchstens 5° einschließen und vorzugsweise im Rahmen üblicher Fertigungstoleranzen zueinander parallel angeordnet sind.

Unter einem Glaswafer (oder Glaselement-Wafer) wird ein Formkörper verstanden, welcher ein Glassubstrat sowie mindestens eine Öffnung umfasst. Mit anderen Worten kann das Glassubstrat als eine Glasscheibe ohne Öffnung verstanden werden, ein Glaswafer als eine Glasscheibe umfassend mehrerer Öffnungen. Ein Glaselement im Sinne der vorliegenden Offenbarung umfasst in der Regel nur eine Öffnung und ist kleiner als ein Glaswafer, insbesondere kann das Glaselement aus einer Vereinzelung eines Glaswafers resultieren. Sofern vorliegend auf Oberflächen eines Glaselements oder Glaswafers abgestellt wird, ergibt sich von selbst, dass diese die Oberflächen des von Glaswafer umfassten Glassubstrats sind. Auch die Dicke des Glassubstrats, des Glaswafers, welcher das Glassubstrat umfasst und des aus dem Glaswafer durch Vereinzelung erhaltenen Glaselements sind in entsprechender Weise gleich. In entsprechender Weise gilt dies auch für die chemische Zusammensetzung des glasigen Materials von Glassubstrat, Glaselement und Glaswafer.

Unter einer Öffnung, die sich von einer Oberfläche des Glaselements (oder Glaswafers) bis zur anderen Oberfläche des Glaselements (oder Glaswafers) erstreckt, wird im Rahmen der vorliegenden Offenbarung eine durchgehende Ausnehmung im Glaselement bzw. Glaswafer bzw. Glassubstrat verstanden. Mit anderen Worten ist im Bereich der Öffnung kein glasiges Material angeordnet. Die Öffnung kann daher auch als Kanal oder Loch bezeichnet werden. Ein Glaselement, welches eine solche Öffnung umfasst, ist mithin rahmenförmig ausgebildet. Dies bedeutet, dass das glasige Material die Öffnung umschließt bzw. umgibt. Unter einem rahmenförmigen Glaselement wird vorliegend insbesondere auch verstanden, dass das rahmenförmige Glaselement genau eine Öffnung umfasst.

Geometrisch kann die Öffnung beschrieben werden als Hohlkörper mit einer, oder gegebenenfalls zwei Grundflächen, die dem Querschnitt der Öffnung an den jeweiligen Seiten des Glaselements bzw. Glaswafers entsprechen, sowie einer Höhe, die der Dicke des Glaselements/Glaswafers entspricht. Die Grundflächen der Öffnung werden auch als Querschnittsflächen bezeichnet. Sind beide Grundflächen gleich groß, kann auch davon gesprochen werden, dass die Öffnung eine Querschnittsfläche aufweist. Sofern auf die Größe der Querschnittsfläche abzustellen ist, kann dabei allgemein der Mittelwert der Querschnittsflächen angegeben werden für den Fall, dass die Größe der Querschnittsfläche der Öffnung über die Höhe variiert. Allgemein kann die Öffnung beschrieben werden als ein Hohlkörper in Form eines Prismas oder Kegels oder für den Fall einer über die Höhe der Öffnung variierenden Größe der Querschnittsfläche als Pyramidenstumpf, oder Kegelstumpf für den Fall, dass die Größe der Querschnittsfläche in Richtung von einer Oberfläche des Glaselements stetig zunimmt. Auch ist es theoretisch möglich, dass sich die Form der Querschnittsfläche wandelt. Aus prozess- und fertigungstechnischer Hinsicht ist es jedoch bevorzugt, dass die Form der Querschnittsfläche gleichbleibt und lediglich die Größe variieren kann.

Die Öffnung ist weiterhin durch eine Seitenfläche begrenzt, nämlich durch die Wandung der Öffnung, welche durch das glasige Material des Glaselements/-substrats gebildet ist. Die Seitenfläche entspricht für den Fall der Ausgestaltung der Öffnung als Prisma dem Mantel eines Prismas, oder, je nach genauer Ausgestaltung, einem Mantel eines Pyramidenstumpfs, einem Kegelmantel, oder einem Mantel eines Kegelstumpfs. Kompliziertere geometrische Ausgestaltungen der Seitenfläche sind denkbar, aber aus prozess- und fertigungstechnischen Gründen nicht bevorzugt.

Allgemein kann die Querschnittsfläche im Prinzip eine beliebige Form aufweisen und beispielsweise sind Ausgestaltungen mit einer runden Querschnittsfläche prinzipiell denkbar. Es ist jedoch im Rahmen der vorliegenden Offenbarung vorteilhaft, dass die Querschnittsfläche in der Form ausgebildet ist, dass sie durch einen geraden Abschnitt, vorzugsweise mit einer Mindestlänge von mindestens 10 $\mu$m, bevorzugt mindestens 20 $\mu$m oder sogar und besonders bevorzugt mindestens 100 $\mu$m, begrenzt ist. Eine solche Ausgestaltung kann gerade für die Verwendung des Glaselements in Drucksensoren vorteilhaft sein. Denn es hat sich gezeigt, dass auf diese Weise, d.h. insbesondere wenn die Form der Membran, vorzugsweise bestmöglich, durch die darunterliegende Öffnung nachgeformt wird, - in der Messkavität eines Drucksensors Druckspitzen vermieden werden und es mithin zu einer gleichmäßigeren Belastung der Siliziummembran, insbesondere einer gleichmäßigeren Belastung der Siliziummembran über die Zeit, kommt. Mit anderen Worten können durch eine solche Ausgestaltung der Querschnittsfläche zeitliche Druckschwankungen zumindest vermindert werden. Dies kann aufgrund der geringeren mechanischen Belastung der Siliziummembran die Lebensdauer eines mit einem solchem Glaselement ausgestatteten Drucksensors vorteilhaft erhöhen. Grundsätzlich ergibt also die Nutzung eines nicht runden Querschnittelements eines Designs einer Öffnung die Möglichkeit, Schwingungsmoden an der Membran vorteilhaft zu gestalten, sprich Lage und Intensität von Schwingungen zu steuern. Selbst sehr kleine gerade Abschnitte können hier Beiträge leisten: Die minimale Länge eines geraden Abschnittes liegt bei mindestens 10 $\mu$m, bevorzugt mindestens 20 $\mu$m. Bestenfalls sind sogar mindestens 100 $\mu$m Länge möglich, wobei bevorzugt die Länge höchstens 2 mm beträgt, besonders bevorzugt maximal 1,7 mm.

Insbesondere hat sich gezeigt, dass eine Öffnung mit einer nicht runden Querschnittsfläche, beispielsweise einer eckigen Querschnittsfläche Vorteile hat, unter anderem, wenn es um eine Verwendung des Glaswafers bzw. Glaselements in einem Drucksensor geht. In der Regel sind nämlich die Messkavitäten in den Siliziummembranen solcher Drucksensoren, wie beispielsweise kapazitiver oder piezoresistiver Drucksensoren, ebenfalls meist eckig, häufig quadratisch, aufgebaut. Die Messkavität ist dabei vom Querschnitt her größer als die Öffnung im Glaselement. Es zeigt sich, dass bei einer eckigen Öffnung, insbesondere einer Öffnung, die einen Querschnitt aufweist, welcher dem der Kavität ähnlich ist, also beispielsweise eine entsprechende Form aufweist, bei Druckbeaufschlagung die resultierende Flächenlast geringer ist. Dies ist vorteilhaft, weil auf diese Weise die Belastung auf die gebondeten Grenzflächen zwischen der Siliziummembran und dem Glaselement geringer ist, diese also nicht so leicht delaminieren. Mit anderen Worten weisen solche Drucksensoren eine höhere Berstdruckstabilität auf, können also bei höheren Drücken eingesetzt werden.

Hier haben sich die folgenden Zusammenhänge in Berechnungen gezeigt:

- Je größer die resultierende freie Fläche des Glaselements unter der Siliziummembran ist, also je mehr nicht an die Siliziummembran gebondete Glasfläche in der Messkavität vorliegt, desto geringer ist der Unterschied zwischen einer Öffnung mit einem runden Querschnitt und einem unrunden Querschnitt, also einem Querschnitt mit einer Querschnittsfläche, welche wenigstens einen geraden Abschnitt aufweist. Dies bedeutet im Umkehrschluss, dass gerade bei kleinen resultierenden freien Flächen ein gerader Abschnitt der Querschnittsfläche oder eine eckige Ausbildung der Querschnittsfläche von besonderer Bedeutung sind.

- Je größer die resultierende freie Fläche ist, desto größer ist die bei Druckbeaufschlagung resultierende Flächenlast und damit die Wirkkraft.

- Je größer der beaufschlagte Druck im Sensor ist, desto besser ist es, eine nur kleine resultierende freie Fläche zu haben. Denn umso geringer ist die Belastung der gebondeten Grenzflächen.

Generell gilt, dass bei einem Wechsel der Querschnittsgeometrie von rund auf eckig, d.h. beim Wechsel von einer runden Querschnittsfläche mit einem Durchmesser x zu einer zumindest annähernd quadratischen Querschnittsfläche mit einer Kantenlänge x, welche dem Durchmesser x der runden Querschnittsfläche entspricht, die resultierende freie Fläche etwa 27% kleiner ist. Gerade bei kleinen resultierenden freien Flächen wirkt sich dies deutlich auf die Wirkkraft aus.

Insbesondere ist dies relevant für Hochdruckanwendungen, also Drucksensoren ausgelegt für einen Druck von wenigstens 30 bar und mehr.

Die resultierende freie Fläche (oder resultierende Fläche), auf welche vorstehend Bezug genommen wird, ergibt sich aus der Differenz der lateralen Abmessung oder Abmessungen der Kavität und derjenigen der Öffnung im Glaselement.

Dies wird durch die Beispielrechnung in der folgenden Tabelle gezeigt. Berechnet wurde hier am Beispiel einer quadratischen Kavität mit der Kantenlänge 1,18 mm.

| | Laterale Abmessung | Querschnittsfläche | Resultierende freie Fläche | Druck | Kraft |
|---|---|---|---|---|---|
| | mm | mm$^2$ | mm$^2$ | N/mm$^2$ | N |
| Kavität □ | 1,18 | 1,39 | | 2 | |
| Abstand Kavität-Öffnung | **0,20** | | | | |
| Öffnung Ø | 0,78 | 0,48 | 0,91 | | **1,8** |
| Öffnung □ | 0,78 | 0,61 | 0,78 | | **1,6** |
| | Diff. | 27% | | | **-14%** |
| **Flächenverhältnis Kavität/Öffnung Ø** | | | | | **~2,91** |
| **Flächenverhältnis Kavität/Öffnung□** | | | | | **~2,29** |

Die Wirkkraft ist für diesen Fall einer quadratischen Kavität also bei einer gleichfalls quadratischen Querschnittsfläche der Öffnung des Glaselements um 14 % geringer als für den Fall einer runden Querschnittsfläche. Diese vorteilhafte Eigenschaft schlägt insbesondere bei kleinen resultierenden freien Flächen zu Buche bzw. insbesondere auch für den Fall, dass das Verhältnis der Querschnittsfläche der Kavität zur Querschnittsfläche der Öffnung klein ist, also beispielsweise weniger als 10 oder weniger als 5 beträgt.

Hierfür wurde in der vorstehenden Tabelle die entsprechende Flächenverhältnisse Kavität/Öffnung Ø (für die runde Öffnung) bzw. Kavität/Öffnung □ (für die eckige, in diesem Falle sogar quadratische, Öffnung) berechnet. Bei den erhaltenen kleinen Verhältnissen der Flächen zueinander resultiert für den Fall einer unrunden Öffnung hier wie ausgeführt eine Differenz in der Wirkkraft im zweistelligen Prozentbereich.

Weniger ausgeprägt ist dies bei größeren Flächenverhältnissen.

Dies kann beispielhaft an den in der nachfolgenden Tabelle aufgeführten Daten entnommen werden:

|  | Laterale Abmessung | Querschnittsfläche | Resultierende freie Fläche | Druck | Kraft |
|---|---|---|---|---|---|
|  | mm | mm² | mm² | N/mm² | N |
| Kavität □ | 2,5 | 6,25 |  | 1 |  |
| Abstand Kavität-Öffnung | **1,00** |  |  |  |  |
| Öffnung Ø | 0,5 | 0,20 | 6,05 |  | **6,1** |
| Öffnung □ | 0,5 | 0,25 | 6,00 |  | **6,0** |
|  | Diff. | 27% |  |  | **-1%** |
| **Flächenverhältnis Kavität/Öffnung Ø** |  |  |  |  | **~31,8** |
| **Flächenverhältnis Kavität/Öffnung□** |  |  |  |  | **~25** |

Bei dem vorstehenden Beispiel ist also der Vorteil durch eine eckige im Vergleich zu einer runden Querschnittsfläche nicht mehr so stark ausgeprägt, vielmehr ergibt sich bei dieser insgesamt großen resultierenden freien Fläche von jeweils ca. 6 mm² nur ein geringer Unterschied in der Wirkkraft.

Mit anderen Worten gilt, dass eine besonders gute Wirkung bei einem Wechsel von einer runden Geometrie zu einer unrunden Geometrie der Querschnittsfläche dann vorliegt, wenn das Verhältnis der Querschnittsfläche der Kavität zur Querschnittsfläche der Öffnung klein ist. nämlich vorzugsweise kleiner als 10, insbesondere kleiner als 5. In der ersten der beiden vorstehenden Tabelle ist der Effekt besonders stark ausgeprägt, hier ist das Verhältnis der Querschnittsflächen von Kavität und Öffnung zueinander sogar kleiner als 3.

Unter einer Nachformung, bevorzugt einer bestmöglichen, der Form der Membran durch die darunterliegende Öffnung wird im Rahmen der vorliegenden Offenbarung verstanden, dass die Form der Membran der Form der Öffnung insofern entspricht, dass die Seitenverhältnisse von Membran und Öffnung im Wesentlichen gleich sind. Unter im Wesentlichen gleichen Seitenverhältnissen wird hierbei verstanden, dass die Membran und die Öffnung eine voneinander abweichende Größe der Querschnittsfläche aufweisen können und/oder dass der Eckenradius von Membran und Öffnung gegebenenfalls abweichen kann. Bis auf diese Abweichungen entspricht allerdings gemäß dieser Ausführungsform die Form Querschnittsfläche der Öffnung der Form der Membran. Gemäß einer Ausführungsform des Glaswafer wird die Form der Membran, beispielsweise einer Siliziummembran, durch die darunterliegende Öffnung nachgeformt, sodass die Form der Membran, beispielsweise der Siliziummembran, der Form der Öffnung insofern entspricht, dass die Seitenverhältnisse von Membran, insbesondere Silizummembran, und Öffnung gleich sind.

Es kann besonders vorteilhaft sein, wenn die Querschnittsfläche durch zwei oder mehr gerade Abschnitte begrenzt ist, beispielsweise durch vier gerade Abschnitte. Insbesondere kann die Querschnittsfläche in Form eines Polygons ausgebildet sein. Vorzugsweise ist die Querschnittsfläche rechteckig oder quadratisch ausgebildet. Auf diese Weise ist innerhalb der Messkavität eines mit einem solchen Glaselement ausgestatteten Drucksensors eine besonders gleichmäßige Druckverteilung möglich. Unter einer polygonalen, beispielsweise rechteckigen oder quadratischen Ausgestaltung der Querschnittsfläche wird hier auch verstanden, dass die Ecken eines solchen Polygons abgerundet vorliegen oder zumindest vorliegen können.

Weiterhin hat sich gezeigt, dass die Seitenfläche eine Oberfläche aufweist, welche gekennzeichnet ist durch eine Skewness Ssk, bestimmt nach der folgenden Formel

$$\mathrm{Ssk} = \frac{1}{S_q^3}\left[\frac{1}{A}\iint_A \left(Z(x,y)^3\right)dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder der Betrag der Skewness höchstens 2,0, besonders bevorzugt höchstens 1,5 ist,

wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt.

Die Skewness wird bevorzugt in einem ebenen Bereich der Seitenfläche bestimmt wird, vorzugsweise in einem Bereich, welcher dem geraden Abschnitt entspricht. Der Bereich, welcher dem geraden Abschnitt entspricht, kann dabei mit dem ebenen Bereich der Seitenfläche identisch sein oder teilidentisch. Es ist je nach genauer Ausgestaltung der Öffnung beispielsweise auch möglich, den Bereich, welcher dem geraden Abschnitt entspricht als einen Teilbereich des ebenen Bereichs der Seitenfläche zu verstehen. Für den Fall einer Ausgestaltung der Öffnung beispielsweise mit einem Querschnitt, dessen Querschnittsform einem Rechteckt entspricht, beispielsweise eines Rechtsecks mit abgerundeten Ecken, wird der ebene Bereich der Seitenfläche von vier Rechtecken gebildet, welche auch verstanden werden können als der Mantel eines Prismas. Die Skewness wird hier insbesondere in einem dieser Rechtecke des Mantels bestimmt, wobei diese Rechtecke jeweils auch einem geraden Abschnitt der Querschnittsfläche der Öffnung zugeordnet werden können.

Mit anderen Worten wird nach der vorliegenden Offenbarung vorzugsweise eine Oberfläche bzw. eines Bereichs einer Oberfläche einer Öffnung in einem Glaselement erzeugt, welche eine nicht symmetrische bzw. nicht gleichmäßige Verteilung von Erhöhungen bzw. Vertiefungen aufweisen. Dies kann insbesondere für eine Verwendung eines aus einem Glaswafer nach Ausführungsformen der vorliegenden Offenbarung hergestellten rahmenförmigen Glaselements in einem Drucksensor vorteilhaft sein. Denn durch die nicht-symmetrische bzw. nicht gleichmäßige Verteilung von Erhöhungen bzw. ggf. Vertiefungen kann eine Verteilung von turbulenten und laminaren Strömungsanteilen von Fluiden, wie Flüssigkeiten und Gasen hin beispielweise zu einer funktionellen Silizium-MEMS-Membran erzeugt bzw. gezielt beeinflusst werden.

So kann eine definierte Gestaltung der Oberfläche in wenigstens einem Bereich den Strömungswiderstand der Öffnung sowohl erhöhen als auch reduzieren:

Strukturen längs zur Strömungsrichtung haben das Potential, analog zum biologischen Beispiel der Haifischhaut, den Strömungswiderstand signifikant zu reduzieren. Eine derartige Oberfläche bietet das Potential, das dynamische Ansprechverhalten des Sensors zu verbessern.

Strukturen quer zur Strömungsrichtung oder unregelmäßige Strukturen erhöhen den Strömungswiderstand. Bei einem externen Druckstoß auf den Sensor führt eine so gestaltete Oberfläche dazu, dass Fluid nur langsam in die Sensor-(bzw. Mess-)kavität nachfließen kann, wodurch die Sensormembran weniger schlagartig belastet wird als mit einer unstrukturierten Oberfläche.

Derselbe Effekt tritt auf, wenn der Druck auf den Sensor plötzlich reduziert wird - bei einer quer zur Strömungsrichtung strukturierten Oberfläche entweicht das Medium langsam aus der Kavität und die dynamische Belastung des Sensors wird gegenüber einer unstrukturierten Oberfläche reduziert.

Durch beide Effekte in Kombination lässt sich so die Dämpfung des schwingfähigen Systems Kavität-Sensormembran gezielt einstellen, um z.B. Eigenschwingungen des Systems gezielt zu verschieben, die Lebensdauer des Sensors zu erhöhen oder in bestimmten Frequenzbereichen besonders hohe Signalqualität zu erreichen.

Ebenfalls denkbar ist eine asymmetrische Strukturierung der Wandoberfläche, die einen hohen Strömungswiderstand in die eine Richtung, aber einen deutlich niedrigeren in die andere Richtung bedeutet.

Neben der Fluidbewegung in die Kavität durch Bewegung der Membran sind auch Wellenphänomene durch die Kompressibilität des Mediums nicht zu vernachlässigen:

Bei impulsartigen Belastungen läuft eine Verdichtungs- bzw. Verdünnungswelle durch die Öffnung auf die Sensormebran zu. Diese wird innerhalb der Kavität reflektiert und führt dadurch zu einer hochfrequenten Belastung der Sensormembran, deren Amplitude in derselben Größenordnung liegt wie der Drucksprung selbst.

Eine gezielte Strukturierung der Oberfläche der Öffnung hat hier den Vorteil, dass diese Welle bereits innerhalb der Öffnung diffus reflektiert wird, vergleichbar mit diffusen Reflektoren in Tonstudios oder Konzertsälen, wodurch der Druckanstieg an der Sensormembran selbst weniger impulshaft geschieht.

Dabei ist es vorteilhaft, dass eine Mindest-Skewness vorliegt, die Oberfläche der Seitenfläche in wenigstens einem Bereich also gezielt eine ungleiche Verteilung von Höhen und Tiefen aufweist. Vorteilhaft kann es aber sein, wenn die Verteilung nicht zu schief ist, da es sonst möglicherweise zu einem Überwiegen ungünstiger Strömungsanteile kommen kann.

Die Ausprägung Oberflächenmorphologie der Seitenwand bzw. Seitenfläche der Öffnung können über Prozessparameter bei der Erzeugung der Öffnung bzw. der Öffnungen gezielt eingestellt werden.

Gemäß einer Ausführungsform ist die Oberfläche in der Form ausgebildet, dass sie überwiegend Vertiefungen ("valleys") aufweist. In diesem Falle ist die Skewness kleiner als 0. Gemäß einer anderen Ausführungsform können auch überwiegend Berge ("hills") vorliegen, entsprechend ist dann die Ssk größer als 0.

In der vorstehenden Formel bezeichnet $S_q$ den quadratischen Mittelwert (root mean square) der Höhe, welcher sich nach der folgenden Formel berechnet:

$$Sq = \sqrt{\frac{1}{A} \iint_A Z^2(x,y)\,dx\,dy}$$

A ist die Fläche des Messbereichs, x und y sind die Flächenkoordinaten des betrachteten Bereichs (Messbereichs) und z gibt die Höhe an. Die Skewness (oder Schiefe) Ssk gibt den Grad der Symmetrie in der Verteilung der Oberflächenhöhen um die mittlere Höhe an. Sie kann daher als Maß dafür verstanden werden, ob in einer Oberflächentopographie eher "Täler" bzw. Vertiefungen oder Erhöhungen dominieren. Sind Erhöhungen und Vertiefungen gleich verteilt, nimmt die Skewness den Wert 0 an. Für den Fall einer Oberfläche, die überwiegend Vertiefungen aufweist, nimmt Ssk einen negativen Wert an. Überwiegen Höhen, ist der Ssk positiv, weist also einen Wert von mehr als 0 auf. Vorzugsweise wird die Skewness bestimmt innerhalb einer gemessenen Fläche von mehr als 0,1 mm$^2$ und vorzugsweise weniger als 3 mm$^2$.

Die vorliegende Erfindung nimmt Bezug auf Topologie von Innenoberflächen von Seitenflächen von Öffnungen, wobei diese besondere Topologie bevorzugt in wenigstens einem Bereich der Oberfläche der Seitenfläche vorliegt, vorzugsweise in einem Bereich, der wenigstens einem geraden Abschnitt der Querschnittsfläche zugeordnet ist, die sich infolge von Strukturierungsprozessen ergeben. Strukturierungstechniken sind vielfältig, ebenso die dazu verwendeten Parameter. Je nach Anwendungen müssen die Innenoberflächen unterschiedliche Charakteristika aufweisen.

Vorliegend wird bevorzugt eine Oberfläche der Seitenfläche der Öffnung erhalten, welche überwiegend durch Vertiefungen, fallweise auch Erhöhungen, insbesondere auch kalottenförmige, also halbkugelförmige, Vertiefungen bzw. Erhöhungen, gekennzeichnet ist, bereitgestellt. Überraschenderweise hat sich gezeigt, dass eine solche Einstellung der Oberfläche zu einer verbesserten mechanischen Stabilität des Glaselements führt. Es wird vermutet, dass dies darauf zurückzuführen ist, dass in bzw. auf der Seitenfläche der Öffnung nach der vorliegenden Offenbarung ein besonders günstiger Bindungszustand an der Oberfläche erhalten werden kann, der beispielsweise durch einen im Wesentlichen chemischen Abtrag der Oberfläche erhältlich ist. Dies bedeutet mit anderen Worten, dass die Oberfläche der Seitenfläche sich dadurch auszeichnet, dass gerade schwache, chemisch angreifbare Bindungen des Glasnetzwerks aufgebrochen wurden, wohingegen starke Bindungen zunächst noch erhalten bleiben und somit im Ergebnis zu einer insgesamt guten mechanischen Stabilität des Glaselements führen. Insbesondere kann das Auftreten von Ausmuschelungen der Öffnung auf diese Weise zumindest gemindert werden.

Die Ausprägung der kalottenförmigen Innenwandstrukturen kann über Prozessparameter gezielt eingestellt werden. Im Falle einer beispielhaften Anwendung eines rahmenförmigen Glaselements in einem Drucksensor hat sich gezeigt, dass eine nicht symmetrische/ nicht gleichmäßige Verteilung von Bergen und Tälern strömungstechnische Vorteile haben kann z.B. in der Verteilung von turbulenten und laminaren Strömungsanteilen von Flüssigkeiten und Gasen hin zu einer funktionellen Si-MEMS-Membran. Wie vorstehend ausgeführt, können durch eine maßgeschneiderte Innenwandstruktur einer Öffnung auch möglicherweise Signalverstärkungen in bestimmten Frequenzbereichen erzeugt werden. Auch könnte es sein, dass damit bestimmte Frequenzbereiche zumindest unterdrückt werden können, sodass ein geringeres Rauschen des Signals resultieren könnte.

Gemäß einer Ausführungsform ist die Querschnittsfläche durch wenigstens zwei gerade Abschnitte begrenzt, wobei die geraden Abschnitte eine Ecke mit einem Krümmungsradius von wenigstens 10 μm, bevorzugt mindestens 20 μm, besonders bevorzugt mindestens 50 μm, und vorzugsweise höchstens 1000 μm, bevorzugt höchstens 500 μm, besonders bevorzugt höchstens 250 μm, mehr bevorzugt höchstens 150 μm, ganz besonders höchstens 130 μm, am meisten bevorzugt höchstens 100 μm, bilden. Dies ist vorteilhaft, weil auf diese Weise Druckspitzen an den Ecken der Querschnittsfläche eines solchen in einem Drucksensor verbauten Glaselements unterdrückt werden können.

Gemäß einer weiteren Ausführungsform umfasst das Glassubstrat ein Glas mit wenigstens 50 Gew.-% SiO$_2$, bevorzugt wenigstens 55 Gew % SiO$_2$, besonders bevorzugt wenigstens 70 Gew.-% SiO$_2$, ganz besonders bevorzugt wenigstens 78 Gew.-% SiO$_2$, wobei der Gehalt des Glases an SiO$_2$ vorzugsweise auf höchstens 85 Gew.-% SiO$_2$, bevorzugt auf höchstens 83 Gew.-% SiO$_2$, begrenzt ist. Mit anderen Worten ist das Glas als vorzugsweise hoch SiO$_2$-reiches Glas ausgebildet. Dies ist vorteilhaft, weil auf diese Weise ein Glas erhalten wird, das einem Ätzprozess z.B. mit Kaliumhydroxid auf besonders effiziente Weise zugänglich ist. Die vorteilhaften Oberflächenstrukturen der Seitenfläche der Öffnung können also in einem solchen Glas bzw. Glaselement bzw. Glaswafer bzw. Glassubstrat auf besonders einfache Weise erzeugt werden. Jedoch sollte der Gehalt des Glases an SiO$_2$ nicht zu hoch sein, denn sonst ist die Schmelzbarkeit des Glases verringert. Vorzugsweise ist daher der Gehalt des Glases an SiO$_2$ begrenzt und beträgt gemäß einer Ausführungsform höchstens 85 Gew.-%, bevorzugt sogar höchstens 83 Gew.-%. Durch die Einstellung des SiO$_2$-Gehalts in den vorgenannten Grenzen ist das Glassubstrat einem effizienten Ätzprozess zugänglich und gleichzeitig in wirtschaftlichen Fertigungsprozessen herstellbar.

Gemäß einer weiteren Ausführungsform umfasst das Glassubstrat (bzw. in entsprechender Weise das Glaselement bzw. der Glaswafer) ein Glas mit wenigstens 1,5 Gew% B$_2$O$_3$, bevorzugt wenigstens 2,0 Gew % B$_2$O$_3$, besonders

bevorzugt wenigstens 2,5 Gew% $B_2O_3$, ganz besonders wenigstens 5 Gew.-% $B_2O_3$, wobei der Gehalt des Glases an $B_2O_3$ vorzugsweise auf höchstens 15 Gew.-% begrenzt ist. $B_2O_3$ ist eine Glaskomponente, die allgemein die chemische Beständigkeit von Gläsern erhöht. Auch senkt ein gewisser Gehalt an $B_2O_3$ den Schmelzpunkt des Glases und verbessert somit die Schmelzbarkeit. Dies ist besonders bei hoch $SiO_2$-haltigen Gläsern vorteilhaft. Nach einer Ausführungsform umfasst daher das Glas bzw. das dieses glasige Material umfassende Glassubstrat mindestens 1,5 Gew.-%, vorzugsweise mindestens 2,0 Gew % $B_2O_3$, besonders bevorzugt wenigstens 2,5 Gew% $B_2O_3$, ganz besonders wenigstens 5 Gew.-% $B_2O_3$. Dies ist insbesondere günstig, wenn das aus dem Glassubstrat erhältliche bzw. dieses umfassende Glaselement in Drucksensoren verwendet werden soll, bei denen korrosive Medien mit dem Glas bzw. dem Glaselement in Kontakt treten sollen.

Auf der anderen Seite ist ein zu hoher Gehalt des Glases an $B_2O_3$ nachteilig, denn er würde dazu führen, dass die Ätzbarkeit des Glases reduziert und damit die Fertigung des Glaselements verlangsamt und mithin unwirtschaftlich werden würde. Daher ist der Gehalt des Glases an $B_2O_3$ vorzugsweise begrenzt und beträgt gemäß einer weiteren Ausführungsform nicht mehr als 15 Gew.-%.

Gemäß einer nochmals weiteren Ausführungsform umfasst das Glassubstrat ein Glas mit wenigstens 2 Gew.-% $Al_2O_3$, wobei der Gehalt des Glases an $Al_2O_3$ vorzugsweise auf höchstens 25 Gew.-% begrenzt ist.

$Al_2O_3$ ist eine bevorzugte Komponente, denn $Al_2O_3$ ist eine Komponente, die gerade in Borosilikatgläsern Entmischung verhindert und daher die Produzierbarkeit des Glases vorteilhaft unterstützt. Daher umfasst das Glas bzw. das dieses Glas umfassende Glaselement nach einer Ausführungsform mindestens 2 Gew.-% $Al_2O_3$. Allerdings kann ein zu hoher Gehalt des Glases bzw. Glaselements an $Al_2O_3$ nachteilig sein, denn $Al_2O_3$ ist eine Komponente, die die chemische Beständigkeit, insbesondere die Säurebeständigkeit, eines Glases herabsetzen kann. Dies ist insbesondere dann nachteilig, wenn das Glas bzw. das dieses Glas umfassende Glaselement im Einsatz mit korrosiven Medien in Kontakt tritt, wie dies bei Drucksensoren beispielsweise im Abgasbereich der Fall sein kann. Daher sollte der Gehalt des Glases an $Al_2O_3$ nicht mehr als 25 Gew.-% betragen.

Gemäß einer weiteren Ausführungsform weist die Querschnittsfläche einen mittleren Flächeninhalt zwischen mindestens 0,04 mm$^2$ und höchstens 2,7 mm$^2$ auf. Auf diese Weise ist ein kompaktes, also kleines und raumsparendes, Design eines Drucksensors möglich. Äquivalentdurchmesser solcher Querschnittsflächen können somit beispielsweise zwischen 0,3 mm und 0,9 mm liegen.

Gemäß einer nochmals weiteren Ausführungsform umfasst der Glaswafer mehrere Öffnungen, wobei die Stegbreite zwischen den Öffnungen mindestens 0,3 mm, bevorzugt mindestens 0,5 mm und vorzugsweise höchstens 7 mm, bevorzugt höchstens 5 mm ist. Dies ist vorteilhaft, denn auf diese Weise ist ein effizientes Herstellen mehrerer Öffnungen gleichzeitig möglich. Glaswafer in einem üblichen Format sind auch gut in etablierten Prozesses händel- und verschickbar.

Die Raumnutzung eines strukturierten Glaswafers oder Sheets, sprich die Ermöglichung möglichst vieler Einzelelemente, ist in vielen Anwendungen entscheidend, da kostenrelevant. So zeigt sich, dass die Nutzung von annähernd quadratischen oder rechteckigen Löchern, beispielsweise quadratischen oder rechteckigen Löchern mit abgerundeten Ecken, im Vergleich zu runden Löchern mit gleichem Flächeninhalt zu einer um mehrere Prozentpunkte größeren Zahl an Einzelelementen führen kann.

Gemäß einer weiteren Ausführungsform liegt bei dem Glaswafer, der mehrere Öffnungen umfasst, das Verhältnis zwischen den Öffnungen und der Gesamtfläche des Glaselements zwischen 0,1 % und 12 %, bevorzugt zwischen 0,2 % und 10 %. Damit ist eine ausreichende Stabilität des Glaswafers für übliche Handlingsprozesse sichergestellt.

Gemäß einer nochmals weiteren Ausführungsform liegt die Dicke des Glaselementes bzw. Glaswafers zwischen mindestens 200 μm, bevorzugt mindestens 300 μm, und höchstens 3500 μm, bevorzugt höchstens 3000 μm, besonders bevorzugt höchstens 2000 μm, ganz besonders bevorzugt höchsten 1800 μm, bestenfalls höchstens 1000 μm, sodass ein Verhältnis zwischen der Dicke des Glaselements/Glaswafers und der mittleren lateralen Abmessung, beispielsweise dem Äquivalentdurchmesser, der Querschnittsfläche zwischen mindestens 0,33 und höchstens 3 gebildet ist. Die Dicke des Glaselements bzw. des Glaswafers ist dabei zum einen ein bestimmender Faktor hinsichtlich der mechanischen Stabilität von Glaselement bzw. Glaswafer und sollte daher nicht zu gering sein, um erhöhten Glasbruch zu vermeiden. Auf der anderen Seite sollte aus Kosten- und Gewichtsgründen sowie zur Realisierung von kleinteiligen Bauteilen, wie beispielsweise Drucksensoren, die Dicke nicht zu groß sein. Weiterhin hat sich gezeigt, dass die mechanische Stabilität eines Drucksensors sowie die Güte der Messdaten eines solchen Drucksensors weiter verbessert werden kann, wenn ein bestimmtes Verhältnis zwischen der Dicke des Glaselements und der mittleren lateralen Abmessung der Querschnittsfläche gebildet ist. Die mittlere laterale Abmessung der Querschnittsfläche kann beispielsweise für den Fall einer über die Höhe der Öffnung variierenden Größe der Querschnittsfläche der mittlere Äquivalentdurchmesser sein. Die Angabe des Äquivalentdurchmessers zur Charakterisierung der Größe der Querschnittsfläche ist gerade für den Fall von Querschnittsflächen mit polygonaler Ausbildung, wie sie nach der vorliegenden Offenbarung bevorzugt sind, vorteilhaft. Der Äquivalentdurchmesser der Öffnung ist hierbei der Durchmesser, den ein Kreis mit demselben Flächeninhalt wie die betrachtete, aber nicht kreisrunde, Querschnittsfläche aufweist. Dicken von Drucksensorgläsern können beispielsweise liegen zwischen mindestens 0,4 mm und höchstens 0,9 mm, aber auch Dicken von 1,6 mm oder 2,7 mm sind möglich, wobei vorzugsweise geringe Dicken von beispielsweise 200 $\mu$m bevorzugt sind.

Gemäß einer Ausführungsform weist der Glaswafer eine Dickenvariation von weniger als 10 $\mu$m, bevorzugt weniger als 5 $\mu$m, besonders bevorzugt weniger als 2 $\mu$m, ganz besonders bevorzugt weniger als 1 $\mu$m, auf.

Gemäß einer Ausführungsform weist die Seitenfläche der Öffnung einen Neigungswinkel auf, welcher vorzugsweise höchstens 2° ist, wobei der Neigungswinkel hier die Abweichung von einer ideal gerade verlaufenden Seitenfläche (oder Seitenwand) ist, welche mit den Oberflächen des Glaswafers einen Winkel von 90° bilden würde.

Gemäß einer weiteren Ausführungsform ist wenigstens eine Oberfläche des Glaswafers und/oder des Glaselements poliert, weist also vorzugsweise eine Rauigkeit $R_a$ von < 2nm, bevorzugt < 1nm auf. Vorzugsweise handelt es sich dabei um diejenige Oberfläche des Glaselements bzw. des Glaswafers, welche dazu vorgesehen ist, mit einer Siliziummembran verbunden zu werden.

Dies ist vorteilhaft, weil auf diese Weise eine nur wenig raue Oberfläche vorliegt, welche sich besonders gut verbinden lässt. Hier hat sich gezeigt, dass eine solche Politur der Oberfläche eines Glaswafers allerdings gerade im Bereich von Öffnungen kritisch zu sehen ist, weil es hier aufgrund mechanischer Beschädigungen des Glases gerade im Kantenbereich der Öffnung zum Abplatzen kommen kann (sogenanntes Chipping). Überraschenderweise hat sich gezeigt, dass gerade durch die Kombination einer geätzten Öffnung gemäß dieser Offenbarung, wie dies auch im nachfolgend beschriebenen Verfahren genauer erläutert wird, bei welchem es zu einer vorteilhaften Ausgestaltung der Oberfläche durch Einstellung einer Skewness in den in der vorliegenden Offenbarung spezifizierten Grenzen kommt, mit einer mechanischen Oberflächenpolitur hier Vorteile liegen, denn diese Kombination der Ätzung und der mechanischen Politur kann Abplatzungen im Randbereich vermindern oder vorteilhaft sogar ganz vermeiden.

Ein weiterer Aspekt betrifft ein bevorzugtes Verfahren zur Herstellung eines Glaswafers oder eines Glaselements umfassend wenigstens eine Öffnung, insbesondere eines Glaselements oder Glaswafers nach einer Ausführungsform, umfassend die Schritte

- Bereitstellen eines scheibenförmigen Glassubstrats
- Richten eines Laserstrahls eines Ultrakurzpulslaser auf eine der Oberflächen des scheibenförmigen Glassubstrats, wobei der Laserstrahl mittels einer Fokussierungsoptik zu einem langgezogenen Fokus im scheibenförmige Glassubstrat geformt wird, sodass durch die eingestrahlte Energie des Laserstrahls eine filamentförmige Schädigung im Volumen des scheibenförmigen Glassubstrats erzeugt wird, deren Längsrichtung senkrecht zu der Oberfläche des scheibenförmigen Glassubstrats ist, und wobei zur Erzeugung einer filamentförmigen Schädigung der Ultrakurzpulslaser einen Puls, oder ein Pulspaket mit mindestens zwei aufeinanderfolgenden Laserpulsen einstrahlt,
- Führen des Auftreffpunkts des Laserstrahls auf dem scheibenförmigen Glassubstrat entlang einer vorgegebenen geschlossenen Linie, sodass eine Vielzahl von nebeneinander auf der vorgegebenen Linie liegenden filamentförmigen Schädigungen im scheibenförmigen Glassubstrat erhalten werden, wobei vorzugsweise die Filamente von einer Seite des scheibenförmigen Glassubstrats zur anderen reichen,
- Ätzen des scheibenförmigen Glassubstrats zumindest in dem Bereich, in welchem filamentförmige Schädigungen im scheibenförmigen Glassubstrats gebildet sind, in einem flüssigen Ätzmedium, wobei die filamentförmigen Schädigungen zu Kanälen aufgeweitet werden, sodass durch das Ätzen der Durchmesser der Kanäle so weit vergrößert wird, dass zwischen den Kanälen befindliches glasiges Material des scheibenförmigen Glassubstrats abgetragen wird, sodass sich die Kanäle vereinigen und eine Öffnung umrahmen, die einen Querschnitt mit einer Querschnittsfläche aufweist, wobei die Querschnittsfläche durch einen geraden Abschnitt, vorzugsweise mit einer Mindestlänge von mindestens 10 $\mu$m, bevorzugt mindestens 20 $\mu$m oder sogar und besonders bevorzugt mindestens 100 $\mu$m, begrenzt ist, wobei die Öffnung eine Seitenfläche aufweist, die eine Oberfläche aufweist, welche gekennzeichnet ist dadurch, dass sie eine Skewness Ssk, bestimmt nach der folgenden Formel

$$Ssk = \frac{1}{S_q^3}\left[\frac{1}{A}\iint_A \left(Z(x,y)^3\right) dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder
der Betrag der Skewness höchstens 2,0, besonders bevorzugt höchstens 1,5 ist,
- optional Vereinzeln des Glassubstrats (1) unter Erhalt eines Glaselements,

wobei $S_q$ die mittlere quadratische Rauigkeit der Oberfläche, beziehungsweise den RMS-Wert, bezeichnet, A die Fläche des Integrationsgebietes, für welches der Ssk-Wert (oder die Skewness) bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert $Z(x,y)$ positiv ist, wenn ein Punkt des Oberflächenprofils höher als der Mittelwert liegt, und negativ, wenn der Punkt unterhalb des Mittelwerts liegt, wobei besonders bevorzugt die Skewness in einem ebenen Bereich der Seitenfläche bestimmt wird, vorzugsweise in dem Bereich, welcher dem geraden Abschnitt entspricht.

Unter einer filamentförmigen Schädigung wird hier eine lange, dünne Schädigung verstanden. Allgemein wird unter einem Filament ein langgestreckter dünner Körper oder eine langgestreckte Struktur verstanden, wobei unter langgestreckt verstanden wird, dass die Länge der Struktur oder des Körpers wenigstens eine, vorzugsweise wenigstens zwei Größenordnungen größer ist als die räumliche Ausdehnung in den beiden anderen, zur Länge senkrechten, Abmessungen des Körpers oder der Struktur, insbesondere also beispielsweise zum Äquivalentdurchmesser der sich senkrecht zur Länge des Körpers oder der Struktur erstreckenden Querschnittsfläche. Eine filamentförmige Schädigung weist also eine nur geringe Querschnittsfläche im Vergleich zur Länge der Schädigung auf.

Das vorstehende Verfahren hat sich als besonders vorteilhaft erwiesen. Die Anmeldung soll aber nicht auf dieses Verfahren limitiert sein. Alternativ können Verfahren wie CNC Bohren, Ultraschallschwingläppen, Sandstrahlen, lokales Ätzen genutzt werden.

Dadurch, dass die filamentförmigen Schädigungen entlang einer zuvor vorgegebenen Linie im bzw. auf dem scheibenförmigen Glassubstrat erzeugt werden, ist es auf sehr einfache Art möglich, die Kontur der mittels des Verfahren im scheibenförmigen Glassubstrat erzeugten Öffnung zu bestimmen. Insbesondere ist es auf diese Art besonders leicht möglich, dass eine Öffnung erzeugt wird, welche durch einen geraden Abschnitt, vorzugsweise mit einer Mindestlänge von mindestens 10 $\mu$m, bevorzugt mindestens 20 $\mu$m oder sogar und besonders bevorzugt mindestens 100 $\mu$m, begrenzt ist. Aber auch andere Geometrien der Öffnung sind möglich und es ist auf diese Weise prinzipiell auch denkbar, komplexe Geometrien der Öffnungen zu erzeugen. Vorzugsweise können allerdings mittels des Verfahrens gerade polygonale Querschnittsformen erzeugt werden, beispielsweise auch rechteckige und/oder quadratische Flächenformen, welche auch mit gerundeten Ecken vorliegen können. Dies kann insbesondere durch die geeignete Wahl der Linienform in Kombination mit dem Ätzen des Glasmaterials zwischen den Schädigungen erzielt werden.

Vorteilhafterweise wird als Ätzmedium ein alkalisches Ätzmedium bevorzugt.

Dabei hat es sich gezeigt, dass insbesondere eine vorteilhafte Ausgestaltung der Oberfläche der Seitenfläche der Öffnung erhalten werden kann, beispielsweise durch eine geschickte Wahl der Abtragsrate. Gemäß einer bevorzugten Ausführungsform wird das glasige Material des Glaselements deshalb mit einer Abtragsrate von kleiner als 5 $\mu$m pro Stunde abgetragen.

Alternativ oder zusätzlich kann die Form der Querschnittsfläche und/oder die Ausgestaltung der Oberfläche der Seitenfläche der Öffnung vorteilhaft beeinflusst werden, wenn die Ätzdauer mindestens 12 Stunden beträgt.

Ein solches Verfahren kann beispielsweise in einem basischen Ätzbad mit einem pH-Wert von mehr als 12 durchgeführt werden. Bevorzugt ist eine KOH-Lösung, insbesondere mit einer Konzentration von KOH von mehr als 4 mol/l, besonders bevorzugt von mehr als 5 mol/l, ganz besonders bevorzugt von mehr als 6 mol/l, wobei jedoch die Konzentration geringer sein sollte als 30 mol/l. Das Ätzen kann gemäß einer Ausführungsform unabhängig vom verwendeten Ätzmedium bei einer Temperatur des Ätzbads von mehr als 70°C, vorzugsweise mehr als 80°C, besonders bevorzugt mehr als 90°C, aber unterhalb von 100°C, durchgeführt werden.

Gerade das zielgerichtete Ablaufen des Materialabtrags und/oder das Einbringen der filamentförmigen Schädigung ist insbesondere auch beeinflussbar durch eine geeignete Materialauswahl. Es hat sich hierbei gezeigt, dass hochsilikathaltige Gläser, also Gläser, welche einen $SiO_2$-Gehalt von mindestens 50 Gew.-%, bevorzugt wenigstens 55 Gew % $SiO_2$, besonders bevorzugt wenigstens 70 Gew.-% $SiO_2$ aufweisen, zur Herstellung eines Glaselements nach den vorliegenden Ausführungsformen insbesondere nach dem vorstehend beschriebenen Verfahren besonders geeignet sind.

Gemäß einer Ausführungsform kann sich an das Ätzen ein mechanisches Polieren wenigstens einer Oberfläche anschließen, insbesondere derjenigen Oberfläche, welche in einem Drucksensor einer Siliziummembran zugewandt ist.

Eine besonders vorteilhafte Glaszusammensetzung kann hierbei sein, wenn das Glas als Borosilikatglas ausgestaltet ist. Denn in der Kombination von $SiO_2$-Gehalt und $B_2O_3$-Gehalt kann ein guter Kompromiss zwischen noch ausreichender Schmelzbarkeit des Glases bei ausreichender chemischer Beständigkeit für eine spätere Anwendung des Glaselements beispielsweise im Kontakt mit korrosiven Medien, beispielsweise in einem Drucksensor für den Automotive-Bereich, und immer noch ausreichender Ätzbarkeit in einem nasschemischen Ätzprozess erzielt werden. Als vorteilhaft hat sich daher ein Glaselement umfassend ein Glas herausgestellt, wobei das Glas zwischen 50 Gew.-% und 85 Gew.-% $SiO_2$, bevorzugt zwischen 78 Gew.-% und 83 Gew.-% $SiO_2$, sowie zwischen wenigstens 1,5 Gew.-% $B_2O_3$, bevorzugt wenigstens 2,0 Gew % $B_2O_3$, besonders bevorzugt wenigstens 2,5 Gew% $B_2O_3$, ganz besonders wenigstens 5 Gew.-% $B_2O_3$ und 15 Gew.-% $B_2O_3$ umfasst.

Aufgrund der bekannten Neigung von Borosilikatgläsern kann es weiterhin vorteilhaft sein, wenn das Glas alternativ eine Komponente umfasst, die der Entmischung entgegenwirkt. Vorteilhaft umfasst daher das Glas bzw. das Glaselement nach einer Ausführungsform neben $SiO_2$ und $B_2O_3$ in den genannten Gehalten noch $Al_2O_3$ als Komponente,

bevorzugt zu mindestens 2 Gew.-%. $Al_2O_3$ ist aber andererseits auch eine Komponente, die einen starken Einfluss auf die chemische Beständigkeit eines Glases haben kann. So ist bekannt, dass $Al_2O_3$ in bestimmten Gläsern auch zu einer Verbesserung der chemischen Beständigkeit gerade im alkalischen Bereich führen kann. Daher sollte der Gehalt des Glases an $Al_2O_3$ zur Sicherstellung einer noch ausreichenden Ätzbarkeit des Glases durch ein alkalisches Ätzmedium nicht zu hoch sein und ist daher vorzugsweise auf höchstens 25 Gew.-% begrenzt. Es hat sich gezeigt, dass ein solches Glas, welches $SiO_2$, $B_2O_3$ und $Al_2O_3$ in den vorstehend genannten Grenzen umfasst, überraschenderweise einem eher langsamen Ätzverfahren, also mit einer eher geringen Ätzrate und/oder einer langen Ätzdauer, zugänglich ist, was vorteilhaft für die Ausbildung einer bestimmten Oberflächenausgestaltung ist.

Glaselemente umfassend, oder aus einem Glas umfassend die folgenden Komponenten in Gew.-% hergestellt, haben sich als besonders bevorzugt zur Bereitstellung eines Glaselements nach Ausführungsformen und/oder herstellbar in einem Verfahren nach Ausführungsformen herausgestellt:

Zusammensetzungsbereich 1

| | |
|---|---|
| $SiO_2$ | 60 bis 65 |
| $B_2O_3$ | 6 bis 10,5 |
| $Al_2O_3$ | 14 bis 25 |
| MgO | 0 bis 3 |
| CaO | 0 bis 9 |
| BaO | 3 bis 8 |
| ZnO | 0 bis 2, |

wobei gilt, dass die Summe des Gehalts von MgO, CaO und BaO dadurch gekennzeichnet ist, dass sie im Bereich von 8 bis 18 Gew.-/ liegt.

Zusammensetzungsbereich 2

| | |
|---|---|
| $SiO_2$ | 60 bis 85 |
| $B_2O_3$ | 5 bis 20 |
| $Al_2O_3$ | 2 bis 15 |
| $Na_2O$ | 3 bis 15 |
| $K_2O$ | 3 bis 15 |
| ZnO | 0 bis 12 |
| $TiO_2$ | 0,5 bis 10 |
| CaO | 0 bis 0,1 |

Zusammensetzungsbereich 3

| | |
|---|---|
| $SiO_2$ | 75 bis 85 |
| $B_2O_3$ | 8 bis 15 |
| $Al_2O_3$ | 2 bis 4,5 |
| $Na_2O$ | 1,5 bis 5,5 |
| $K_2O$ | 0 bis 2 |

Zusammensetzungsbereich 4:

| | |
|---|---|
| $SiO_2$ | 20 bis 70, bevorzugt 50 bis 60, besonders bevorzugt 52 bis 58 |
| $B_2O_3$ | 0,5 bis 14, bevorzugt 2 bis 12, besonders bevorzugt 2 bis 4 |
| $Al_2O_3$ | 15 bis 41, bevorzugt 16 bis 24, besonders bevorzugt 18 bis 23 |
| MgO | 0,5 bis 15, bevorzugt 2 bis 12, besonders bevorzugt 3 bis 5 |
| CaO | 0 bis 5, bevorzugt 0 bis 3 |
| BaO | 0 bis 7, bevorzugt 0 bis 6 |
| ZnO | 0 bis 20, bevorzugt 2 bis 12, besonders bevorzugt 8 bis 10 |
| NaO | 0 bis 7, bevorzugt 1 bis 6, besonders bevorzugt 3 bis 5 |

In allen oben genannten Zusammensetzungsbereichen können weiterhin Nebenbestandteile und/oder Spuren, z.B. in Form von färbenden Substanzen und/oder Läutermitteln, so zum Beispiel $SnO_2$, $CeO_2$ , $As_2O_3$ , $Cl^-$, F-, Sulfate, enthalten sein.

Allgemein, ohne Beschränkung auf die hier beschriebenen Zusammensetzungsbereiche, kann es vorteilhaft sein, dass das glasige Material in der Form ausgebildet ist, dass es anodisch verbindbar (oder bondbar) ist. Dazu kann es vorteilhaft sein, wenn das glasige Material einen gewissen Anteil an Alkalien bzw. Alkalioxiden, insbesondere Natrium bzw. Natriumoxid, aufweist.

Der Gehalt von $Na_2O$ sollte bei mindestens 0,5 Gew.-% liegen, aber bevorzugt 6 Gew.-% nicht übersteigen.

Eine vorteilhafte Ausgestaltung des Verfahrens ist es alternativ oder zusätzlich weiterhin, wenn der räumliche Abstand zweier Auftreffpunkte des Laserstrahls auf der wenigstens einen Oberfläche des scheibenförmigen Glassubstrats höchstens 6 µm, vorzugsweise höchstens 4,5 µm beträgt und/oder wenn die Anzahl der Pulse eines Bursts zum Einbringen einer filamentförmigen Schädigung höchstens 2 oder mindestens 7 beträgt und/oder wenn die Pulsdauer des Lasers im Bereich von 0,5 ps bis 2 ps liegt bei einem räumlichen Abstand zweier Auftreffpunkte des Laserstrahls auf der wenigstens einen Oberfläche des scheibenförmigen Glassubstrats von 1 µm bis 15 µm, vorzugsweise bis höchstens 6 µm, beispielsweise bis höchstens 4,5 µm.

Ein nochmals weiterer Aspekt betrifft einen Drucksensor, beispielsweise einen piezoresistiven oder kapazitiven Drucksensor, vorzugsweise einen piezoresistiven Drucksensor, umfassend wenigstens ein Glaselement nach einer Ausführungsform.

Ein solcher Drucksensor kann allgemein wenigstens eine Siliziummembran umfassen.

Bevorzugt ist dabei das Glaselement so ausgebildet, dass die Seitenfläche der Öffnung einen Neigungswinkel aufweist, welcher vorzugsweise höchstens 2° ist. Der Neigungswinkel ist hier die Abweichung von einer ideal gerade verlaufenden Seitenwand, welche mit den Oberflächen des Glaselements einen Winkel von 90° bilden würde.

Auf diese Weise ist das Glaselement so ausgebildet, dass der Flächeninhalt der Öffnung auf einer Oberfläche des Glaselements größer ist als auf der anderen, der ersten Oberflächen gegenüberliegenden Oberfläche des Glaselements. Dabei kann der Drucksensor gemäß einer Ausführungsform so ausgebildet sein, dass die Oberfläche des Glaselements, auf welcher der Flächeninhalt der Querschnittsfläche größer ist, der Siliziummembran zugewandt ist. Dies wird auch als "invertiert konisch" bezeichnet. Es hat sich überraschend gezeigt, dass eine solche Ausgestaltung für die mechanische Stabilität und auch für die Stabilität der Messergebnisse eines Drucksensors vorteilhafter ist, als die umgekehrte Ausgestaltung mit einer zur Siliziummembran hin abnehmenden Querschnittsfläche der Öffnung.

Denn für den Fall, dass die Öffnung des Glaselements auf der der Siliziummembran abgewandten Seite größer ist als auf der der Siliziummembran zugewandten Seite, wirkt die Öffnung wie eine Düse und es kommt zu deutlichen zeitlichen Druckschwankungen in der Messkavität, was nicht nur zu ungenauen Druckmessergebnissen führen kann, sondern auch zu einer erhöhten mechanischen Belastung der Siliziummembran.

Weiterhin hat sich also gezeigt, dass es vorteilhaft sein kann, wenn die Öffnung auf der der Siliziummembran bzw. den Siliziummembranen abgewandten Seite kleiner ist als auf der den Siliziummembranen bzw. der Slliziummebran zugewandten Seite. Beispielsweise steht auf diese Weise auf der der Siliziummembran bzw. den Siliziummembranen abgewandten Seite des Glaselements eine größere Fläche zum Anbinden mit einem weiteren Bauelement zur Verfügung. Dies ist vorteilhaft, da es die mechanische Stabilität eines Verbundes zwischen dem Drucksensor und einem weiteren Bauteil verbessern kann.

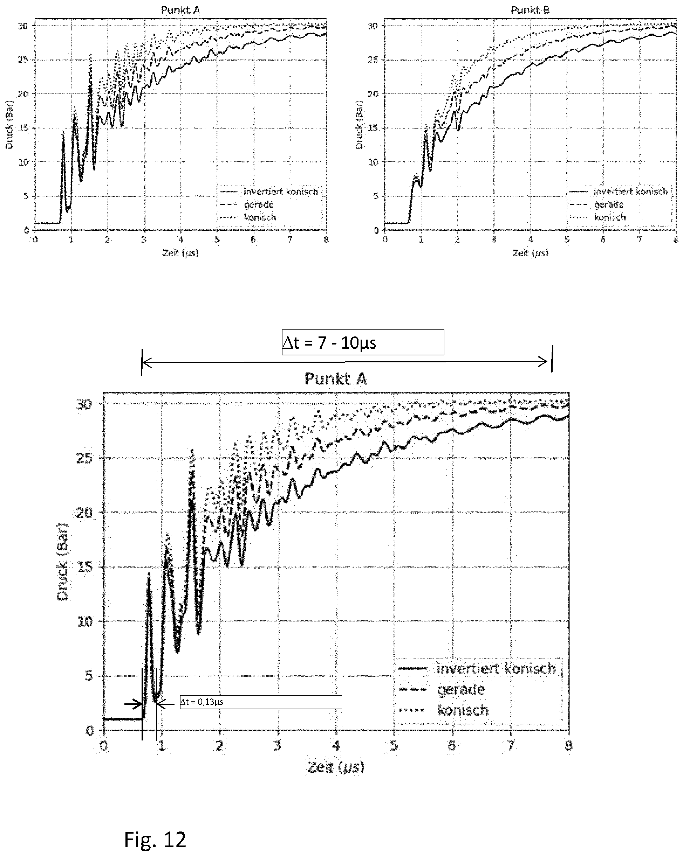

Gemäß einer weiteren Ausführungsform kann es aber auch vorgesehen sein, dass der Drucksensor so ausgestaltet ist, dass die Seitenfläche der Öffnung des Glaselements einen Neigungswinkel aufweist, welcher vorzugsweise höchstens 2° ist, wobei der Neigungswinkel hier die Abweichung von einer ideal gerade verlaufenden Seitenfläche ist, welche mit den Oberflächen des Glaswafers einen Winkel von 90° bilden würde, wobei die Öffnung einen Querschnitt mit einer sich in Richtung zur Siliziummembran verjüngenden Querschnittsfläche aufweist. Mit anderen Worten ist gemäß dieser Ausführungsform die Querschnittsfläche der Öffnung auf der den Siliziummembranen bzw. der Siliziummembran zugewandten Seite kleiner als auf der Seite des Glaselements, welche der Siliziummembran bzw. den Siliziummembranen abgewandt. Dies kann vorteilhaft sein, weil auf diese Weise innerhalb einer kürzeren Zeit der Maximaldruck im Drucksensor erreicht werden kann. Dies kann beispielhaft anhand der nachfolgenden in der Figurenbeschreibung erläuterten Fig. 12 gezeigt werden. Mit einer solchen, sogenannten "konischen" Ausführungsform der Öffnung ist es beispielsweise sogar möglich, dass vorzugsweise eine um mindestens 30%, bevorzugt sogar um mindestens 40% kürzere Zeit zum Erreichen des Maximaldruckes an wenigstens einem Punkt A, B einer vom Drucksensor umfassten Siliziummembran als bei einer gleichbleibenden oder sich erweiterndem Querschnittsfläche der Öffnung erzielt werden kann.

Gemäß einer Ausführungsform ist der Drucksensor so ausgestaltet, dass er ein Glaselement sowie eine Siliziummembran umfasst, wobei die Form der Siliziummembram durch die Öffnung des Glaselements nachgeformt ist, sodass die Form der Siliziummembran der Form der Öffnung insofern entspricht, dass die Seitenverhältnisse von Siliziummembran und Öffnung gleich sind.

Besonders vorteilhaft ist es, wie auch weiter oben zu den technischen Vorteilen und Effekten einer Geometrie der

EP 4 162 246 B1

Querschnittsfläche diskutiert, wenn das Verhältnis der Querschnittsfläche der Kavität zur Querschnittsfläche der Öffnung im Glaselement klein ist. Vorzugsweise ist gemäß einer Ausführungsform das Verhältnis der Querschnittsfläche der Kavität zur Querschnittsfläche der Öffnung kleiner als 10, vorzugsweise kleiner als 5. Gemäß einer Ausführungsform ist der Drucksensor also so ausgestaltet, dass eine Kavität der Siliziummembran eine Querschnittsfläche aufweist und wobei das Verhältnis der Querschnittsfläche der Kavität zu der Querschnittsfläche des Glaselements weniger als 10, vorzugsweise weniger als 5, beträgt.

Mit Glaszusammensetzungen entsprechend der vorstehend genannten Zusammensetzungsbereiche können beispielsweise die in den folgenden Tabellen aufgeführten Skewnesswerte-Ssk erzielt werden. Dabei ist in der obersten Zeile jeweils der Zusammensetzungsbereich des Glases des Glaselements bzw. des Glaswafers aufgeführt. Zur Messung wurden Glaselemente nach Ausführungsformen der vorliegenden Offenbarung verwendet. Dabei wurde die Oberfläche der Seitenwand der Öffnung, vorzugsweise in wenigstens einem Bereich, welche dem geraden Abschnitt der Öffnung zugeordnet werden kann, vermessen. Die Glaselemente wurden dabei vorliegend in einem Verfahren nach der vorliegenden Offenbarung erhalten, d.h. mittels Laserbearbeitung zur Erzeugung eines Filaments bzw. mehrerer Filamente und sodann Durchführung eines Ätzverfahrens. Es wurden unterschiedliche Parameter beim Ätzen verwendet, was in der zweiten Zeile mit "Ätzparameter" angegeben ist.

Schließlich können sich die Parameter der Laserbearbeitung zur Erzeugung der Filamente zwischen den Messpunkten A bis J noch unterscheiden. Es zeigt sich damit anhand der Proben, welche in den beiden folgenden Tabellen aufgeführt sind, dass die Rauigkeit der Oberfläche der Seitenwand der Öffnung unterschiedlich eingestellt werden kann.

| Zusammensetzungsbereich | 4 | 4 | 2 | 2 |
|---|---|---|---|---|
| Atzparameter | 1 | 2 | 1 | 2 |
| A | -0,0042 | -0,0164 | -0,2136 | -0,4591 |
| B | -0,0071 | -0,1241 | -0,5829 | -0,5780 |
| C | -0,1619 | -0,1620 | -0,6534 | -0,6812 |
| D | -0,2337 | -0,1816 | -0,7696 | -0,8759 |
| E | -0,3601 | -0,2167 | -0,8000 | -1,0196 |
| F | -0,3844 | -0,2593 | -0,8510 | -1,0902 |
| G | -0,4503 | -0,3165 | -0,9791 | -1,2563 |
| H | -0,5217 | -0,4029 | -1,0476 | -1,3223 |
| I | -0,5780 | -0,5903 | -1,1321 | -1,4034 |
| J | -0,8341 | -1,1901 | -1,4505 | -1,4850 |

| Zusammensetzungsbereich | 4 | 4 | 2 | 2 |
|---|---|---|---|---|
| Atzparameter | 4 | 5 | 1 | 2 |
| A | 5,1262 | 1,5912 | -0,2136 | 0,1649 |
| B | 1,3716 | 1,0797 | -0,5669 | -0,5217 |
| C | 0,8894 | 0,6995 | -0,6599 | -0,6812 |
| D | 0,1786 | 0,6006 | -0,7732 | -0,8307 |
| E | 0,0030 | 0,4045 | -0,8245 | -1,0037 |
| F | -0,1298 | 0,3053 | -0,9881 | -1,0196 |
| G | -0,2268 | 0,2423 | -0,9985 | -1,0447 |
| H | -0,3165 | 0,0521 | -1,1263 | -1,1642 |
| I | -0,4591 | 0,0011 | -1,2182 | -1,2624 |
| J | -1,1901 | -0,4414 | -1,4505 | -1,4850 |

Beschreibung der Zeichnungen

Im Folgenden wird die Erfindung anhand von Figuren näher erläutert. Dabei beziehen sich gleiche Bezugszeichen auf gleiche oder einander entsprechende Elemente. Es zeigen

Fig. 1 bis 3        schematische und nicht maßstabsgetreue Darstellung von Ausführungsformen von Glaswafern,

17

Fig. 4        eine schematische und nicht maßstabsgetreue Abbildung einer Ausführungsform eines Glaselements,

Fig. 5        eine schematische Darstellung eines Teils eines Glaselements zur Erläuterung des Neigungswinkels,

Fig. 6        eine schematische und nicht maßstabsgetreue Darstellung einer Ausführungsform eines piezoresistiven Drucksensors,

Fig. 7        eine schematische und nichts maßstabsgetreue Darstellung des Verfahrens zur Herstellung eines Glaswafers bzw. eines Glaselements,

Fig. 8        eine schematische und nichts maßstabsgetreue Darstellung eines Glassubstrats als Zwischenprodukt des Verfahrens zur Herstellung eines Glaswafers bzw. Glaselements,

Fig. 9 und 10        Darstellungen zur Erhöhung der Strukturelemente auf einem 6" Wafer bei Übergang von einer runden Öffnung zu einer eckigen Öffnung bei gleichem Volumen der Öffnung,

Fig.11 und 12        das Verhalten eines Drucksensors mit runder Querschnittsgeometrie der Öffnung und unterschiedlich ausgestaltetem Neigungswinkel der Seitenwand bezüglich der. zeitlichen Verteilung eines Druckstoßes,

Fig. 13 und 14        das Verhalten eines Drucksensors mit runder Querschnittsform der Öffnung zu quadratischer Querschnittsform der Öffnung hinsichtlich der zeitlichen Verteilung eines Druckstoßes, sowie

Fig. 15        beispielhafte Darstellungen zum unterschiedlichem Flächenverhältnis der Querschnittsflächen von Kavität und Öffnung.

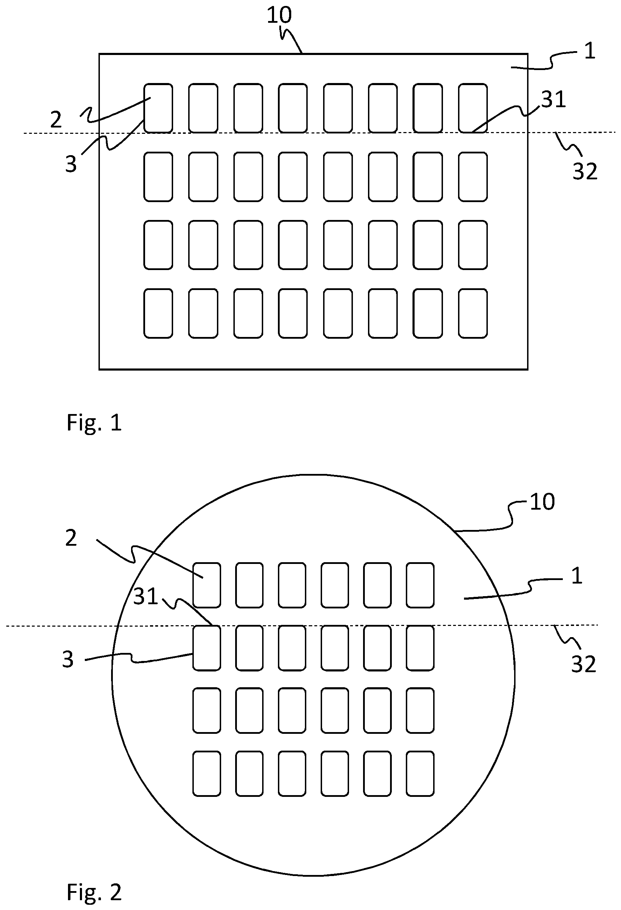

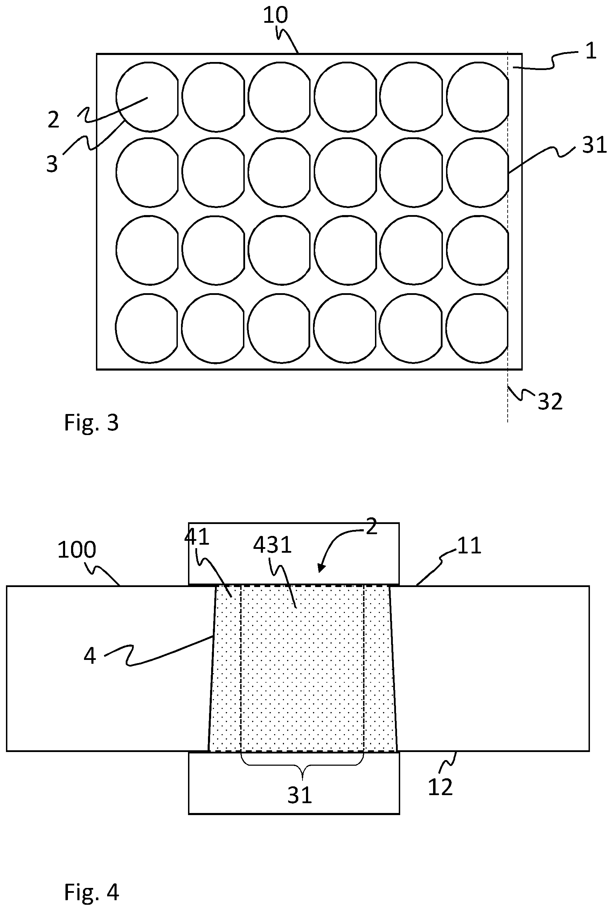

Fig. 1 bis 3 zeigen jeweils schematische und nicht maßstabsgetreue Darstellungen von Glaswafern 10, welche mehrere Öffnungen 2 umfassen. Die Öffnungen 2, welche der Übersichtlichkeit halber nicht alle bezeichnet sind, weisen hier beispielhaft eine Querschnittsfläche 3 auf, die durch einen geraden Abschnitt 31, vorzugsweise mit einer Mindestlänge von mindestens 10 $\mu$m, bevorzugt mindestens 20 $\mu$m oder sogar und besonders bevorzugt mindestens 100 $\mu$m, begrenzt ist. Bei den in Fig. 1 und 2 jeweils dargestellten Glaswafern 10 sind die Querschnittsflächen 3 der Öffnungen 2 jeweils durch vier gerade Abschnitte 31 begrenzt, welche aber der Übersichtlichkeit halber nicht alle eingezeichnet wurden, sodass die Querschnittsflächen 3 hier jeweils die Form eines Rechtsecks aufweisen, und zwar hier beispielhaft ein Rechteck mit abgerundeten Ecken. Allgemein sind aber auch andere Querschnittsflächen, beispielsweise in Form eines Kreissegments, oder allgemein polygonale Querschnittsflächen 3 denkbar, wie dies beispielhaft in Fig. 3 für Öffnungen 2 dargestellt ist. Der besseren Übersichtlichkeit halber sind die Öffnungen 2 hier jeweils groß im Vergleich zum Glaswafer 10 dargestellt; zur Herstellung miniaturisierter Bauteile, wie beispielsweise eines Drucksensors mit einem kompakten Design werden die Öffnungen 2 in der Regel kleiner im Vergleich zu den Abmessungen des Glaswafers 10 sein. Typische Äquivalentdurchmesser von Öffnungen 2 können beispielsweise weniger als 1 mm sein. Weiterhin ist die Gerade 32 dargestellt. Der gerade Abschnitt 31 kann daher auch als Teil einer Gerade 32 verstanden werden.

Fig. 1 bis 3 zeigen jeweils eine Ausgestaltung eines Glaswafers 10 umfassend mehrere Öffnungen 2. Diese Glaswafer 10 sind daher Halbzeuge zur Herstellung von rahmenförmigen Glaselementen 100, die jeweils nur eine Öffnung 2 umfassen. Die in Fig. 1 bis 3 dargestellten Glaswafer 10 ermöglichen eine schnelle und kostengünstige Herstellung. Dies ist vorteilhaft, denn auf diese Weise ist nicht nur ein effizientes Herstellen mehrerer Öffnungen gleichzeitig möglich, sondern ein Glaswafer ist beispielweise auch leichter händel- und verschickbar. Das Vereinzeln und Verbauen in ein miniaturisiertes Bauteil wie einen Drucksensor kann dann gegebenenfalls sogar beim Kunden selbst erfolgen.

Fig. 4 zeigt eine schematische und nicht maßstabsgetreue Darstellung einer Ausführungsform eines rahmenförmigen Glaselements 100, welches lediglich eine Öffnung 2 umfasst. Das Glaselement 100 umfasst ein scheibenförmiges Glassubstrat 1 umfassend eine Oberfläche (oder Hauptfläche oder Seite) 11 sowie eine weitere, der ersten Oberfläche 11 gegenüberliegenden Oberfläche 12. Vorteilhaft kann das Glaselement 100 bzw. das Glassubstrat 1 so ausgebildet sein, dass die Oberflächen 11 und 12 im Rahmen üblicher Fertigungstoleranzen zueinander parallel ausgebildet sind. Das Glaselement 100 (bzw. das Glassubstrat 1) ist hier liegend oder horizontal angeordnet, sodass die Oberfläche 11 hier auch als Oberseite und die Oberfläche 12 auch als Unterseite bezeichnet werden kann.

In Fig. 4 ist das Glaselement 100 in einer Schnittdarstellung dargestellt, wobei der Schnitt durch die Öffnung 2 verläuft. Die Öffnung 2 weist eine Seitenfläche 4 auf, die eine Oberfläche 41 aufweist, welche gekennzeichnet ist durch eine Skewness Ssk, bestimmt nach der folgenden Formel

$$Ssk = \frac{1}{S_q^3}\left[\frac{1}{A}\iint_A (Z(x,y)^3)\, dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder der Betrag der Skewness höchstens 2,0, besonders bevorzugt höchstens 1,5 ist, wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt, wobei besonders bevorzugt die Skewness in einem ebenen Bereich der Seitenfläche 4 bestimmt wird, vorzugsweise in einem Bereich 431, welcher dem geraden Abschnitt 31 entspricht. In der Darstellung von Fig. 4 ist dabei der Bereich 431 in Aufsicht dargestellt. Er ist ein Teil der Seitenfläche 4 und entspricht hier dem Teil der Seitenfläche 4, in welchem die Querschnittsfläche der Öffnung durch den geraden Abschnitt 31 begrenzt ist.

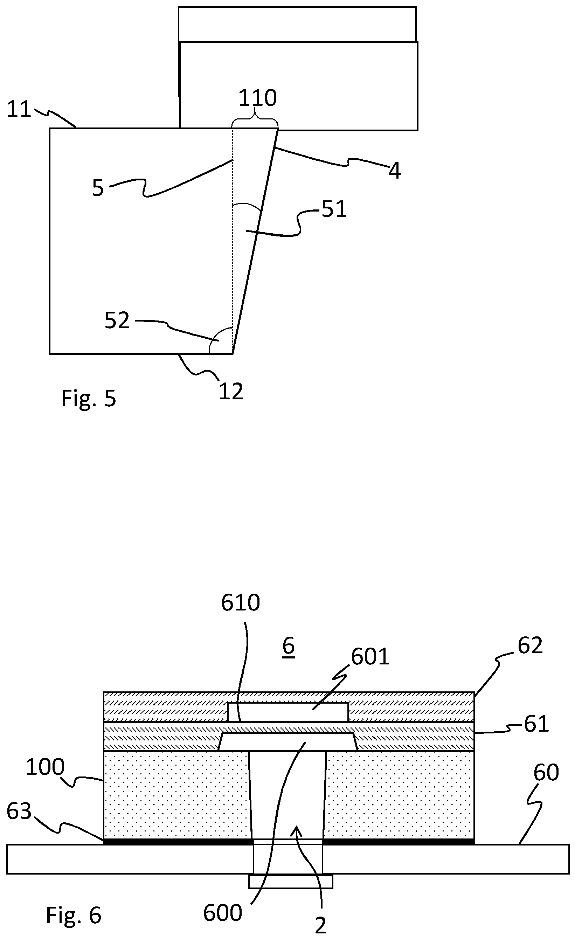

In Fig. 5 ist die Oberfläche 41 der Seitenfläche 4 in Draufsicht schematisch in Form einer gepunkteten Oberfläche dargestellt.

Die Seitenfläche 4 des in Fig. 4 dargestellten Glaselements 100 ist geneigt ausgebildet. Mit anderen Worten weist die Seitenfläche 4 einen Neigungswinkel auf, welcher allerdings in Fig. 4 der Übersichtlichkeit halber nicht dargestellt ist. Denn der Neigungswinkel der Seitenfläche (oder Seitenwand) 4 der Öffnung 2 ist vorzugsweise nur sehr gering ausgebildet

In Fig. 5 ist schematisch und nicht maßstabsgetreu eine Detailansicht eines Teils eines Glaselements 100 (oder eines Glaswafers 10) dargestellt, um den Neigungswinkel 51 der Seitenfläche 4 näher zu erläutern. Die gestrichelte Linie 5 zeigt hier den Verlauf einer hypothetischen Seitenwand (nicht bezeichnet), die ideal gerade verlaufen würde, also im rechten Winkel (Winkel 52) zu den Oberflächen 11, 12 des Glaselements 100 (bzw. das Glassubstrats 1) steht. Mit dieser Linie 5 (die geometrisch auch als "Höhe" eines Dreiecks mit den Seiten 4, 5 sowie 110 verstanden werden kann bzw. bezogen auf das Glaselement 1 auch als die Dicke des Glaselements 1) schließt die Seitenwand 4 des Glaselements 100 (bzw. des Glassubstrats 1) den Winkel 51 ein. Dieser Winkel 51 wird hier auch als Neigungswinkel bezeichnet. Er gibt also die Größe der Abweichung von einer ideal gerade verlaufenden Seitenwand, welche mit den Oberflächen 11, 12 des Glaselements 100 einen Winkel von 90° bilden würde, an. Vorzugsweise ist der Neigungswinkel höchstens 2°, mit anderen Worten ist also die Neigung der Seitenfläche 4 nur sehr gering. Dies hat zur Folge, dass die Größe der Querschnittsfläche 3 der Öffnung 2 über die Höhe der Öffnung 2 nur in sehr geringem Maße variiert. Ausführungsformen, bei welchen die Querschnittsfläche im Rahmen üblicher Fertigungstoleranzen auf beiden Seiten 11, 12 des Glaselements 100 gleich ist, können bevorzugt sein. Gerade für den Einsatz des Glaselements 100 in einem piezoresistiven Drucksensor kann es jedoch vorteilhaft sein, wenn die Größe der Querschnittsfläche 3 auf einer Oberfläche des Glaselements 100 größer ist.

Einen beispielhaften Drucksensor 6 zeigt Fig. 6 in schematischer und nicht maßstabsgetreuer Darstellung. Der Drucksensor 6 ist in einer Schnittdarstellung dargestellt und umfasst einen Sockel 60, welcher beispielsweise aus einem keramischen Material ausgebildet sein kann. Auf dem Sockel 60 ist mittels einer Klebeschicht 63, beispielsweise aus einem Epoxidharz ausgebildet, das Glaselement 100 befestigt. Das Glaselement 100 weist eine Öffnung 2 auf, wobei die Seitenwand 4 hier geneigt ausgebildet ist, sodass die (nicht bezeichnete) Querschnittsfläche 3 der Öffnung 2 auf der Oberfläche 11 größer ist als auf der Oberfläche 12 des Glaselements 1. Zur Messkavität 600 des Drucksensors 6 bzw. hin zur Siliziummembran 62 nimmt also die Größe der Öffnung 2 zu. Der Drucksensor 6 umfasst optional weiterhin noch eine weitere Siliziummembran 61, die die Referenzdruckkavität 601 bildet.

Ohne Beschränkung auf das dargestellte Beispiel kann ein Drucksensor 6 gemäß dieser Offenbarung insbesondere als piezoresistiver oder kapazitiver Drucksensor ausgebildet sein und wenigstens ein Glaselement 100 gemäß dieser Offenbarung umfassen, welches eine Öffnung 2 aufweist, deren Oberfläche die hier beschriebene Struktur mit einer von Null verschiedenen Skewness aufweist. Dabei ist mit dem Glaselement 100 ein Element verbunden, welches für die Druckmessung eine deformierbare Membran aufweist. Gemäß einer bevorzugten Ausführungsform ist hierbei ein Silizium-Element, beziehungsweise eine Siliziummembran 61 mit einem deformierbaren Membranabschnitt 610 vorgesehen. Das Element, wie insbesondere die Siliziummembran 61 ist anodisch auf das Glaselement 100 gebondet. Unabhängig von der Art der Verbindung ist die mit der Membran verbundene Oberfläche des Glaselements 100 gemäß einer bevorzugten Ausführungsform mechanisch poliert. Dies ermöglicht unter anderem eine besonders stabile Verbindung mittels anodischem Bonden. Die mit anodischem Bonden hergestellte Verbindung ist daran zu erkennen, dass die Oberflächen der beiden Elemente direkt miteinander verbunden sind, beziehungsweise in direktem Kontakt stehen. Schließlich weist das mit dem Glaselement 100 verbundene Element, wie insbesondere die Siliziummembran 61 eine Kavität 600 auf, in welche die Öffnung 2 mündet.

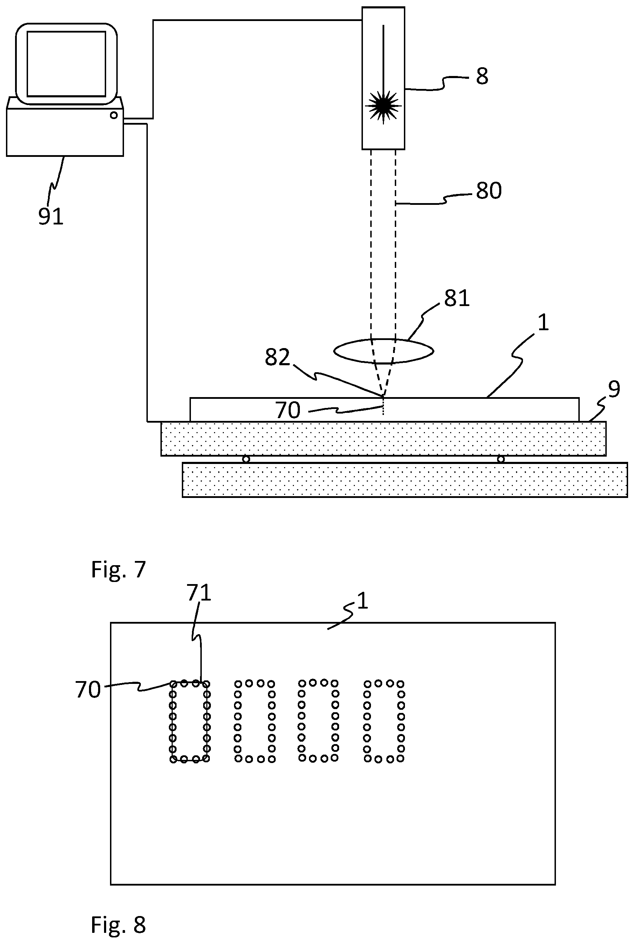

In Fig. 7 ist die Herstellung eines Glaselements 100 bzw. eines Glaswafers 10 gemäß einer Ausführungsform des Verfahrens beschrieben.

Bei dem Verfahren zur Herstellung eines Glaselements 100 bzw. eines Glaswafers wird der Laserstrahl 80 eines Ultrakurzpulslaser 8 auf eine der Oberflächen 11, 12 eines scheibenförmigen Glassubstrats 1 gerichtet. Dabei wird der Laserstrahl 80 mittels einer Fokussierungsoptik 81 zu einem langgezogenen Fokus im scheibenförmigen Glassubstrat 1 geformt. Auf diese Weise wird durch die eingestrahlte Energie des Laserstrahls 80 eine filamentförmige Schädigung 70 im Volumen des scheibenförmigen Glassubstrats 1 erzeugt, deren Längsrichtung senkrecht zu der Oberfläche 11, 12 des scheibenförmigen Glassubstrats 1 ist. Zur Erzeugung einer filamentförmigen Schädigung 70 strahlt der Ultrakurzpulslaser 8 dabei einen Puls oder ein Pulspaket mit mindestens zwei aufeinanderfolgenden Laserpulsen ein. Der Auftreffpunkt 82 des Laserstrahls 80 wird auf dem scheibenförmigen Glassubstrat 1 entlang einer vorgegebenen geschlossenen Linie 71 geführt, sodass eine Vielzahl von nebeneinander auf der vorgegebenen Linie 71 liegenden filamentförmigen Schädigungen 70 im scheibenförmigen Glassubstrat 1 erhalten werden. Dabei reichen vorzugsweise die Filamente 71 von einer Oberfläche 11, 12 des scheibenförmigen Glassubstrats 1 zur anderen Oberfläche 11, 12. Dieses Führen des Auftreffpunkts 82 auf einer geschlossenen Linie 71 kann beispielsweise mittels einer Positionierungseinrichtung 9 erfolgen. Diese kann beispielsweise über eine Recheneinrichtung 91 angesteuert werden. Zweckmäßigerweise kann die Recheneinrichtung 91 auch die Laserleistung steuern. Selbstverständlich ist es aber auch möglich, mehrere Recheneinrichtungen 91 zu verwenden.

Im weiteren Verlauf erfolgt das Ätzen des scheibenförmigen Glassubstrats 1 zumindest in dem Bereich, in welchem filamentförmige Schädigungen 70 im scheibenförmigen Glassubstrat 1 gebildet sind, in einem flüssigen Ätzmedium, wobei die filamentförmigen Schädigungen 70 zu Kanälen aufgeweitet werden. Durch das Ätzen wird der Durchmesser der Kanäle so weit vergrößert, dass das zwischen den Kanälen befindliche glasige Material des scheibenförmigen Glassubstrats 1 abgetragen wird. Mithin vereinigen sich die Kanäle und umrahmen eine Öffnung 2, die einen Querschnitt mit einer Querschnittsfläche 3 aufweist, wobei die Querschnittsfläche 3 durch einen geraden Abschnitt 31, vorzugsweise mit einer Mindestlänge von mindestens 10 $\mu$m, besonders bevorzugt mindestens 20 $\mu$m oder sogar und besonders bevorzugt mindestens 100 $\mu$m, begrenzt ist, wobei die Öffnung 2 eine Seitenfläche 4 aufweist, die eine Oberfläche 41 aufweist, welche gekennzeichnet ist durch eine Skewness Ssk

$$\mathrm{Ssk} = \frac{1}{S_q^3}\left[\frac{1}{A}\iint_A \left(Z(x,y)^3\right) dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder der Betrag der Skewness höchstens 2,0, besonders bevorzugt höchstens 1,5 ist, wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt, wobei besonders bevorzugt die Skewness in einem ebenen Bereich der Seitenfläche 4 bestimmt wird, vorzugsweise in einem Bereich 431, welcher dem geraden Abschnitt 31 entspricht.

Die vorgegebene geschlossene Linie 71 bildet die Kontur der Querschnittsfläche 3.

An die in Fig, 7 dargestellten und anhand dieser erläuterten Schritte kann sich noch eine Politur wenigstens einer Oberfläche des Glaselements bzw. des Glaswafers anschließen. In Fig. 8 ist eine Aufsicht auf ein scheibenförmiges Glassubstrat 1, in welches mehrere filamentförmige Schädigungen 70 eingebracht wurden. Diese wurden der besseren Übersichtlichkeit halber nicht alle bezeichnet. Die filamentförmigen Schädigungen 70 wurden hier in das Glassubstrat 1 in der Form eingebracht, dass sie entlang einer geschlossenen 71 aufgebracht wurden, welche hier beispielhaft die Kontur eines Rechtecks mit abgerundeten Ecken bildet. Für das beispielhaft in Fig. 7 dargestellte Glassubstrat wurden filamentförmige Schädigungen 70 entlang vier geschlossenen Linien 71 eingebracht, sodass in einem anschließenden Ätzprozess hier ein Glaswafer mit vier Öffnungen resultieren würde, aber es versteht sich von selbst, dass die Anzahl der Öffnungen entsprechend der Größe der Öffnungen, der Größe und der Form des scheibenförmigen Glassubstrats angepasst werden können, insbesondere, um eine entsprechende Flächenausnutzung zu erzielen.

Allgemein ist ein solches Verfahren mit einer Filamentierung und einem sich anschließenden Ätzprozess vorteilhaft, weil auf diese Weise kleinere Radien in den Ecken der Öffnung erzielt werden können, was gerade bei der Herstellung von Querschnittsflächen mit wenigstens einem geraden Abschnitt von Vorteil sein kann. Mit dem herkömmlichen USSL-Verfahren wird ein Mindestradius von 150 μm erzielt. Demgegenüber sind mit dem beschrieben Verfahren Radien möglich, welche kleiner als 150 μm, vorzugsweise kleiner 100 μm, sind. Eine Untergrenze des Eckenradius kann allgemein bei 20 μm liegen.

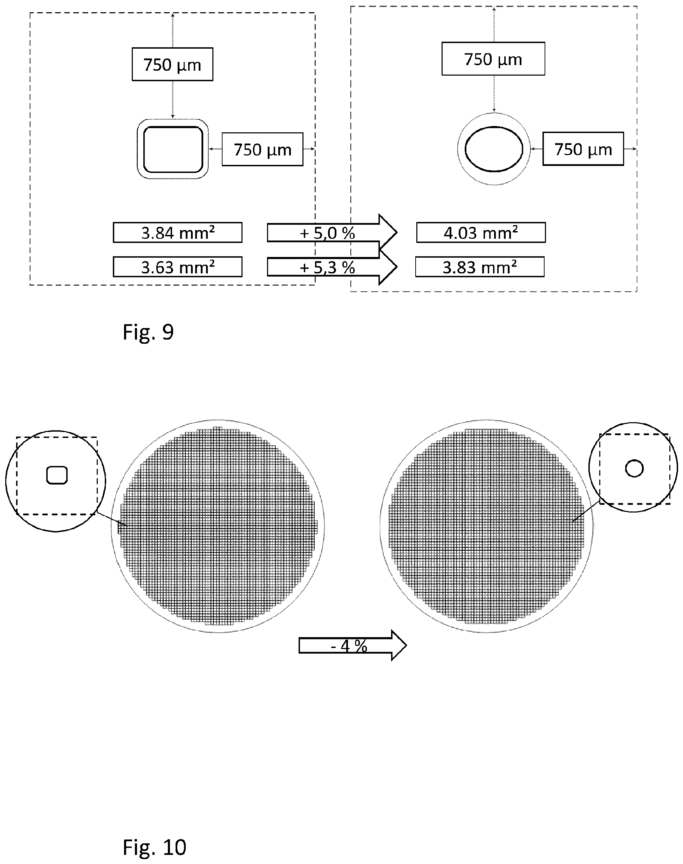

In den Figuren 9 und 10 werden die Vorteile des Überganges von einer runden Öffnung auf eine Öffnung, welche einen Querschnitt mit einer Querschnittsfläche aufweist, die durch wenigstens einen geraden Abschnitt, vorzugsweise mit einer Mindestlänge des geraden Abschnitts von mindestens 10 μm, bevorzugt mindestens 20 μm oder sogar und besonders bevorzugt mindestens 100 μm, begrenzt ist in Bezug auf die Wafer- Belegungsdichte aufgezeigt. Die Öffnung im linken Bereich von Fig. 9 weist Abmessungen von 500 μm * 420 μm auf bei einem Radius der Ecken von 90 μm. Die Öffnung im rechten Bereich von Fig. 9 weist einen Radius von 254,2 μm auf. Berücksichtigt man eine gleiche Durchflussfläche, in diesem Fall 203.000 μm², sowie gleiche Stegbreiten von Wandung der Öffnung zum Rand eines Drucksensorsockels (hier 750 μm), sind die Einzelpodeste im Falle der nicht vollständig runden Öffnung, deren Querschnittsfläche also durch wenigstens einen geraden Abschnitt begrenzt ist, lateral um mehrere Prozentpunkte kleiner. Übertragen auf einen 6"-Wafer ergibt sich hier eine bessere Flächennutzung ebenfalls im Bereich mehrerer Prozentpunkte (Fig. 10) und damit eine Kostenersparnis. In Fig. 9 sind weiterhin auch Prozentzahlen angegeben. Dabei handelt sich um die Gesamtfläche des Glaselements für den Fall der in fig. 9 angegebenen Abmessungen des Glaselements. Diese ist um 5 % größer für den Fall der runden Öffnung. Für den Fall, dass nur die bondbare bzw. verbindbare Fläche des Glaselements (also weniger der Querschnittsfläche der Öffnung) berücksichtigt wird, ist diese für den in Fig. 9 dargestellten Fall der Abmessungen der Öffnungen um 5,3 % größer für den Fall der runden Öffnung. In Fig. 10 zeigt sich, dass die Zahl der Öffnungen, die auf einem Wafer bei ansonsten gleicher Stegbreite realisiert werden können, für den Fall einer runden Geometrie der Öffnung um 4% im Vergleich zu der im linken Teil der Fig. 10 dargestellten Öffnung mit einer Querschnittsfläche, die nicht vollständig rund ist, abnimmt.

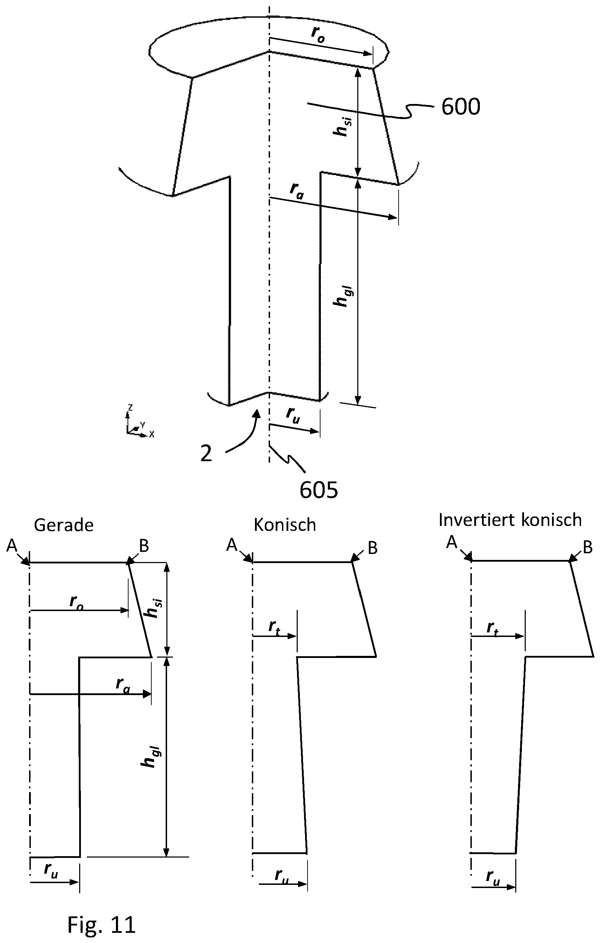

Die Figuren 11 und 12 zeigen Rechnungen und entsprechende Modelle zur Fluiddynamik in einer beispielhaften axialsymmetrischen Drucksensorkavität unter Nutzung einer runden Sockelöffnung mit geraden Wänden im Vergleich mit einer Sockelöffnung mit geneigten Wänden. Als beispielhaftes Medium wird hier im Wesentlichen nicht-kompressibles Wasser genutzt, welches laminar fließt. Dieses strömt mit 30 bar in die Kavität ein und verteilt sich dort aufgrund Reflexionen an den Wandungen zeitlich inhomogen. An zwei beispielhaften Punkten A und B in der Mitte bzw. Seite der Kavitätsmembran liegen zeitlich unterschiedliche Drücke an. Der komplette Druckausgleich erfolgt hier innerhalb von Mikrosekunden.

Die Dauer des Druckausgleiches liegt in erster Näherung unabhängig von der Ausformung der Öffnung (gerade oder nach oben oder unten geneigte Wände) in derselben Größenordnung. Jedoch sind bei sehr sensiblen Druckmessungen, welche höchste Präzision erfordern, auch kleine Shifts gegebenenfalls auschlaggebend. So zeigt sich überraschenderweise, dass insbesondere bei leicht konischen Strukturen eine kürzere Zeit zum Erreichen des Maximaldruckes vorliegt. Auf der anderen Seite bedingen sich verjüngende Strukturen höhere Druckschwankungen bis zum Erreichen des kompletten Druckausgleiches.

Will man einen schnelleren Druckausgleich erreichen, ist alternativ neben einem sich verjüngenden Querschnitt auch eine Öffnung mit grundsätzlich geringerer Querschnittsfläche, wenn auch mit geraden Wänden, von Vorteil.

Weiterhin ergibt sich überraschenderweise aus den Berechnungen, dass sich bei sehr hochfrequenten Anwendungen, d.h. in wie im vorliegenden beispielhaften Fall, bei welchem Druckstöße mit Frequenzen von mehr als 100kHz anliegen, ungünstige, da sehr chaotische Verhältnisse entstehen können. Für solche Anwendungen sind werden Querschnittsformen der Öffnung bevorzugt, bei denen Schwankungen zumindest vermindert, vorzugsweise minimiert, werden können.

Im oberen Bereich der Fig. 11 ist eine beispielhafte Darstellung einer Messkavität 600 gezeigt, welche die Höhe $h_{si}$ aufweist. Die Messkavität 600 ist hier beispielhaft rotationssymmetrisch um die Symmetrieachse 605 ausgebildet. Im oberen Bereich der Messkavität 600 weist diese einen Radius $r_0$ auf. Die Messkavität 600 ist hier also beispielhaft in Form eines geraden Kegelstumpfes ausgebildet, sodass der untere Radius $r_a$ der Messkavität größer ist als $r_0$. An die Messkavität 600 schließt sich hier nach unten der Bereich der Öffnung 2 an. Die Höhe $h_{gl}$ der Öffnung 2 entspricht der Dicke des Glaselements, welches hier allerdings nicht dargestellt ist. die Öffnung 2 ist hier ebenfalls rotationssymmetrisch um die Achse 605 ausgebildet, weist mithin also die Form eines Zylinders mit dem Radius $r_u$ auf.

Im unteren Bereich der Fig. 11 werden drei unterschiedliche fälle der Ausgestaltung der Öffnung 2 (hier nicht bezeichnet) unterschieden. Für den Fall der nicht geneigten Seitenflächen geltenden die Abmessungen wie vorstehend hinsichtlich des oberen Teils der Fig. 11 beschrieben. Dieser Fall wird im linken unteren Teil der Fig. 11 in Form einer schematischen Schnittdarstellung gezeigt und als "gerade" bezeichnet. Im mittleren unteren Bereich der fig. 11 ist der Fall dargestellt, dass die Seitenfläche der Öffnung 2 (nicht bezeichnet) in der Form geneigt ist, dass der Radius rt der Querschnittsfläche der Öffnung in Richtung der Siliziummembran bzw. der Messkavität (jeweils nicht bezeichnet) kleiner ist als der Radius $r_u$. Mit anderen Worten ist also die Querschnittsfläche hin zur Messkavität kleiner als die Querschnittsfläche auf der der Messkavität abgewandten Seite des Glaselements. Dies wird allgemein, beispielsweise auch für den Fall, dass die Öffnung einen Querschnitt mit einer Querschnittsfläche aufweist, welche durch wenigstens einen geraden Abschnitt begrenzt ist, hier und im Folgenden auch als "konisch" bezeichnet. Rechts unten in Fig. 11 ist schließlich der umgekehrte Fall dargestellt, bei welchem $r_u$ kleiner ist als rt. Dies wird hier und im Folgenden, auch für den Fall einer von der runden Form abweichenden Form der Querschnittsfläche, beispielsweise auch für den Fall, dass die Öffnung einen Querschnitt mit einer Querschnittsfläche aufweist, welche durch wenigstens einen geraden Abschnitt begrenzt ist, als invertiert konisch bezeichnet. Wie vorstehend bereits diskutiert, zeigt sich bei der Betrachtung der Berechnungen zeigt sich, dass bei einer sogenannten "konischen" Ausführungsform der Öffnung es beispielsweise sogar möglich ist, dass vorzugsweise eine vorzugsweise um mindestens 30%, bevorzugt sogar um mindestens 40% kürzere Zeit zum Erreichen des Maximaldruckes an wenigstens einem Punkt A, B einer vom Drucksensor umfassten Siliziummembran als bei einer gleichbleibenden oder sich erweiterndem Querschnittsfläche der Öffnung erzielt werden kann. Eine solche Ausführungsform eines Drucksensors kann dabei vorteilhaft sein. Allerdings kann auch der umgekehrte Fall der "invertiert konischen" Ausführung vorteilhaft sein, da hier die Druckschwankungen geringer sind.

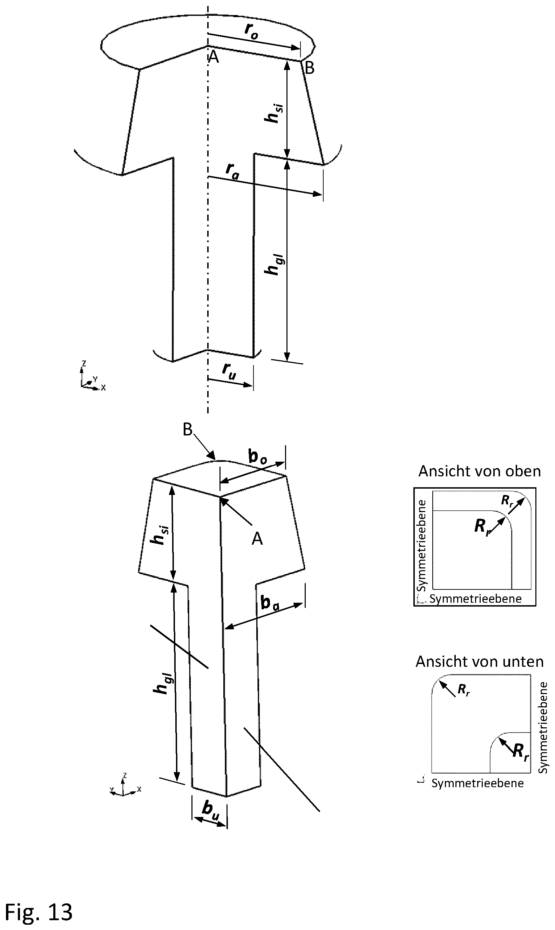

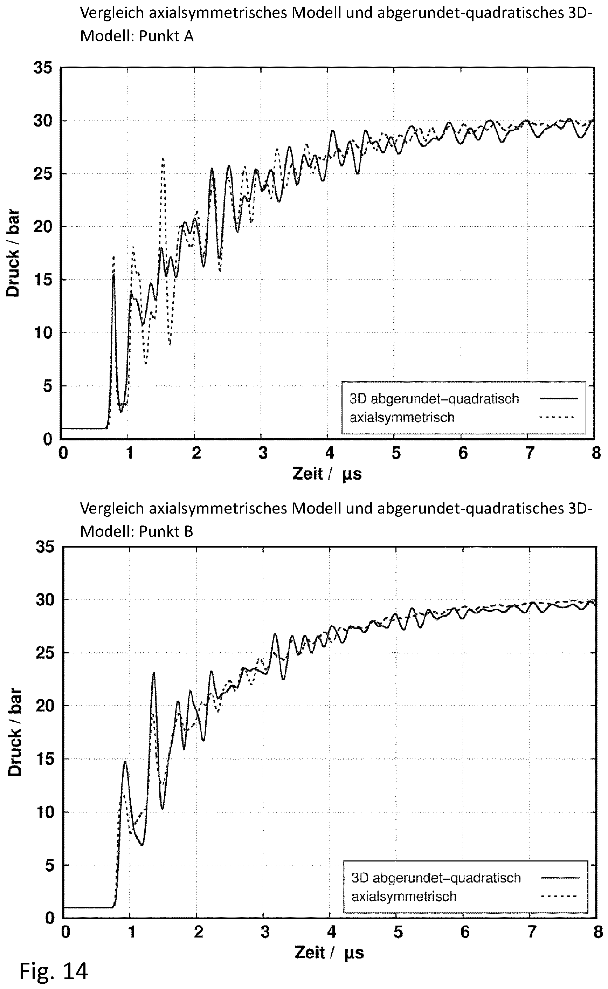

In Figuren 13 und 14 sieht man Simulationen zur Fluiddynamik einer Öffnung mit runder Querschnittsgeometrie im Vergleich mit einer Öffnung mit eckiger Querschnittsgeometrie. Im oberen Bereich ist wiederum die Messkavität mit runder Querschnittsgeometrie entsprechend dem oberen Bereich von Fig. 11 bezeigt. Im unteren Bereich der Fig. 13 ist hingegen der Fall einer Öffnung bzw. einer Messkavität dargestellt, bei denen die Querschnittsgeometrie von der runden Form abweicht, also einen Querschnitt mit einer Querschnittsfläche aufweist, welche durch wenigstens einen geraden Abschnitt, hier vier gerade Abschnitte, gekennzeichnet ist. Die Ecken der entsprechenden Querschnittsflächen sind hier jeweils abgerundet, wie im unteren Bereich von Fig. 13 beispielhaft anhand der Skizzen im rechten Bereich ersichtlich ist. Aufgrund der unterschiedlichen Querschnittsformen sind hier nur die Eckenradien $R_r$ zur Charakterisierung der Abrundung der Ecken bezeichnet, ansonsten aber keine Radien, sondern vielmehr die Abmessungen $b_a$ bzw $b_u$, bzw. $b_0$, bei welchen es sich hier um die halbe Kantenlänge der Messkavität oben ($b_0$), unten (also in Richtung des Glaselements) ($b_a$) und der Öffnung des Glaselements ($b_u$) handelt. Die Bedingungen in der Simulation entsprechen dabei jenen aus Erläuterungen zu den Figuren 11 und 12. Jedoch wurden sowohl die Kavität im Silizium als auch die Zuflussöffnung nicht ideal rund ausgeführt, d.h. zeigen mindestens eine gerade Kante bzw. einen geraden Abschnitt 31. In beiden Modellen liegen die gleichen Strömungsquerschnitte vor.

Analog zu den Rechnungen in Figuren 11 und 12 erfolgt der Druckausgleich im Zeitfenster von Mikrosekunden. Die Schwankungen sind dabei am Rand der Kavität Punkt B geringer als im Zentrum A, was bedeutet, dass Rückreflexionen insgesamt geringer sind. An der Stelle A tritt ein Vorteil einer nicht eckigen Öffnung besonders hervor: die hochfrequenten Schwankungen sind deutlich abgeschwächt, Anwendungen bei hohen Frequenzen dadurch zuverlässiger und genauer monitorbar.

Erfindungsgemäß sind nun auch überraschenderweise nicht nur Geometrieeinflüsse, also Querschnittsgeometrien von Öffnungen, von Bedeutung, sondern auch die Oberflächenmorphologie der Öffnung bzw. von deren Seitenwand oder Seitenfläche an sich. Überraschenderweise kann beobachtet werden, dass nicht symmetrische Bedingungen / Anteilen zwischen Bergen und Tälern den o.g. chaotischen Verhältnissen positiv entgegenwirken können. So können beispielsweise nicht ideal glatte Strukturen zu turbulenten Strömungsanteilen führen, die, in Einklang mit Geometrieeffekten gebracht bzw. gezielt abgewogen, eine ideale Druckbeaufschlagung der Sensorkavität bzw. der sensitiven Si-Membran in Bezug auf Druckgröße, Sättigung und Fluktuation bedingen können.

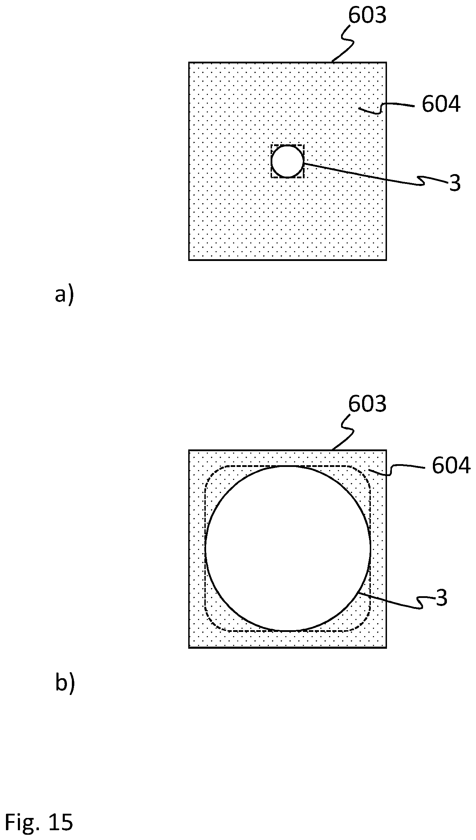

Fig. 15 zeigt schematisch und nicht maßstabsgetreu die Darstellung von Querschnittsflächen 603 von Messkavitäten 600 (jeweils nicht bezeichnet) und Querschnittsflächen 3 bzw. 3a des Glaselements 100. In Fig. 15 a) ist eine Aufsicht auf eine Querschnittsfläche 603 der Messkavität eines Drucksensors dargestellt. Ebenfalls ist die in diesem Fall zentral angeordnete Querschnittsfläche 3 der Öffnung 2 (wobei die Öffnung 2 nicht bezeichnet wurde). Die runde Querschnittsfläche 3 der Öffnung des Glaselements ist hier klein im Vergleich zur Querschnittsfläche 603 der Kavität. Weiterhin dargestellt ist die - hypothetische - eckige Querschnittsfläche 3a einer Öffnung 2 (wiederum nicht bezeichnet), welcher eine Kantenlänge entsprechend des Durchmessers der runden Öffnung 3 aufweist. Aus der Differenz der Querschnittsflächen 603 und 3 (bzw. 603 und 3a) ergibt sich die resultierende freie Fläche 604, d.h. die Fläche, auf welche bei einer Druckbeaufschlagung eine Kraft wirken kann.

Fig. 15 b) zeigt eine entsprechende Darstellung, allerdings mit dem Unterschied, dass hier die resultierende freie Fläche 604 deutlich geringer ist als in Fig. 15 a). Mit anderen Worten ist hier das Verhältnis der beiden Querschnittsflächen 603 und 3 (bzw. 603 und 3a) zueinander deutlich kleiner als im Falle der Darstellung in Fig. 15 a). Wie vorstehend bereits ausgeführt, ist der Einfluss der vorteilhaften Ausgestaltung einer Öffnung mit wenigstens einem geraden Abschnitt - beispielsweise also eine eckige Ausbildung der Öffnung oder mit abgerundeten Ecken - gerade für den Fall der Fig. 15 b) besonders stark ausgeprägt. Denn wie ersichtlich ist, ist gerade in diesem Fall durch den Wechsel von einem runden bzw. kreisrunden Querschnitt zu einem Querschnitt, welcher wenigstens einen geraden Abschnitt aufweist, in der Reduktion der resultierenden freien Fläche 604 besonders effizient.

<u>Bezugszeichenliste</u>

| | |
|---|---|
| Scheibenförmiges Glassubstrat | 1 |
| Glaswafer | 10 |
| Glaselement | 100 |
| Oberflächen | 11, 12 |
| Seite eines Dreiecks | 110 |
| Öffnung | 2 |
| Querschnittsfläche | 3, 3a |
| gerader Abschnitt/gerade Kante | 31 |
| Gerade | 32 |
| Seitenwand, Seitenfläche | 4 |
| Oberfläche der Seitenwand | 41 |
| Bereich entsprechend geradem Abschnitt | 431 |
| Dicke | 5 |
| Winkel, Neigungswinkel | 51 |
| Winkel, rechter Winkel | 52 |
| Drucksensor | 6 |
| Sockel | 60 |
| Siliziummembranen | 61, 62 |
| Klebeschicht, Kleber | 63 |
| Messkavitäten | 600, 601 |
| Querschnittsfläche Kavität | 603 |
| Resultierende freie Fläche | 604 |
| Symmetrieachse | 605 |
| Deformierbarer Membranabschnitt | 610 |
| Filamentförmige Schädigung, Filament | 70 |
| Geschlossene Linie, Kontur | 71 |
| Laser | 8 |
| Laserstrahl | 80 |
| Fokussierungsoptik | 81 |
| Auftreffpunkt | 82 |
| Positionierungseinrichtung | 9 |
| Recheneinrichtung | 91 |
| A, B | Punkte auf der Siliziummembran |
| $h_{si}$ | Höhe der Siliziummembran |
| $h_{gl}$ | Höhe des Glaselements |
| $r_u$ | Radius der Öffnung an der von der Siliziummembran abgewandten Seite |
| $r_a$ | Radius der Messkavität an der dem Glaselement zugewandten Seite |
| $r_t$ | Radius der Öffnung an der der Messkavität zugewandten Seite |
| $r_o$ | Radius der Messkavität an der dem Glaselement abgewandten Seite |

(fortgesetzt)

| $b_u$ | Halbe Abmessung der Öffnung an der von der Siliziummembran abgewandten Seite |
|---|---|
| $b_a$ | Halbe Abmessung der Messkavität an der dem Glaselement zugewandten Seite |
| $b_o$ | Halbe Abmessung der Messkavität an der dem Glaselement abgewandten Seite |
| $R_r$ | Radius der Ecke |

**Patentansprüche**

1. Glaswafer (10) zur Herstellung eines rahmenförmigen Glaselements (100) für die Anwendung in Drucksensoren (6), insbesondere piezoresistiven oder kapazitiven Drucksensoren, bevorzugt piezoresistiven Drucksensoren, umfassend ein scheibenförmiges Glassubstrat (1) sowie wenigstens eine Öffnung (2), die von einer Oberfläche (11) des Glassubstrats (1) zur anderen Oberfläche (12) des Glassubstrats (1) reicht, wobei die Öffnung (2) einen Querschnitt mit einer Querschnittsfläche (3, 3a) aufweist, wobei die Querschnittsfläche (3, 3a) durch einen geraden Abschnitt (31), vorzugsweise mit einer Mindestlänge von mindestens 10 $\mu$m, bevorzugt mindestens 20 $\mu$m oder sogar und besonders bevorzugt mindestens 100 $\mu$m, begrenzt ist, wobei die Öffnung (2) eine Seitenfläche (4) aufweist, die eine Oberfläche (41) aufweist, welche **gekennzeichnet ist durch** eine Skewness Ssk

$$\text{Ssk} = \frac{1}{S_q^3}\left[\frac{1}{A}\iint_A \left(Z(x,y)^3\right) dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder
der Betrag der Skewness höchstens 2,0, besonders bevorzugt höchstens 1,5 ist,
wobei besonders bevorzugt die Skewness in einem ebenen Bereich der Seitenfläche (4) bestimmt wird, vorzugsweise in einem Bereich (431), welcher dem geraden Abschnitt (31) entspricht.
wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt.

2. Glaswafer (10) nach Anspruch 1, wobei die Querschnittsfläche (3, 3a) durch wenigstens zwei gerade Abschnitte (31) begrenzt ist, wobei die geraden Abschnitte (31) eine Ecke mit einem Krümmungsradius von wenigstens 10 $\mu$m, bevorzugt mindestens 20 $\mu$m, besonders bevorzugt mindestens 50 $\mu$m, und vorzugsweise höchstens 1000 $\mu$m, bevorzugt höchstens 500 $\mu$m, besonders bevorzugt höchstens 250 $\mu$m, mehr bevorzugt höchstens 150 $\mu$m, ganz besonders bevorzugt höchstens 130 $\mu$m, am meisten bevorzugt höchstens 100 $\mu$m, bilden.

3. Glaswafer (10) nach einem der Ansprüche 1 oder 2, wobei das Glassubstrat (1) ein Glas mit wenigstens einem der folgenden Merkmale aufweist:

- das Glas umfasst wenigstens 50 Gew.-% $SiO_2$, bevorzugt wenigstens 55 Gew % $SiO_2$, besonders bevorzugt wenigstens 70 Gew.-% $SiO_2$, ganz besonders bevorzugt wenigstens 78 Gew.-% $SiO_2$, wobei der Gehalt des Glases an $SiO_2$ vorzugsweise auf höchstens 85 Gew.-% $SiO_2$, bevorzugt auf höchstens 83 Gew.-% $SiO_2$, begrenzt ist.
- das Glas umfasst wenigstens 1,5 Gew% $B_2O_3$, bevorzugt wenigstens 2,0 Gew % $B_2O_3$, besonders bevorzugt wenigstens 2,5 Gew% $B_2O_3$, ganz besonders wenigstens 5 Gew.-% $B_2O_3$, wobei der Gehalt des Glases an $B_2O_3$ vorzugsweise auf höchstens 15 Gew.-% begrenzt ist.

- das Glas umfasst wenigstens 2 Gew.-% $Al_2O_3$, wobei der Gehalt des Glases an $Al_2O_3$ vorzugsweise auf höchstens 25 Gew.-% begrenzt ist.

4. Glaswafer (10) nach einem der Ansprüche 1 bis 3, wobei die Querschnittsfläche (3, 3a) einen mittleren Flächeninhalt zwischen mindestens 0,04 mm$^2$ und höchstens 2, 7 mm$^2$ aufweist.

5. Glaswafer (10) nach einem der Ansprüche 1 bis 4, wobei die Skewness kleiner als 0 ist.

6. Glaswafer (10) nach einem der Ansprüche 1 bis 5, **gekennzeichnet durch** wenigstens eines der folgenden Merkmale:

   - der Glaswafer umfasst mehrere Öffnungen (2), wobei die Stegbreite zwischen den Öffnungen (2) mindestens 0,3 mm, bevorzugt mindestens 0,5 mm und vorzugsweise höchstens 7 mm, bevorzugt höchstens 5 mm, ist.
   - der Glaswafer umfasst mehrere Öffnungen (2), und das Verhältnis zwischen den Öffnungen (2) und der Gesamtfläche des Glaswafers (10) liegt zwischen 0,1% und 12%, bevorzugt zwischen 0,2% und 10%.
   - die Dicke des Glassubstrats (1) liegt zwischen mindestens 200 $\mu$m, bevorzugt mindestens 300 $\mu$m, und höchstens 3500 $\mu$m, bevorzugt höchstens 3000 $\mu$m, besonders bevorzugt höchstens 2000 $\mu$m, ganz besonders bevorzugt höchstens 180 $\mu$m, bestenfalls bei max. 1000 $\mu$m liegt, sodass ein Verhältnis zwischen der Dicke des Glassubstrats (1) und der mittleren lateralen Abmessung der Öffnung zwischen mindestens 0,33 und höchstens 3 gebildet ist.

7. Glaswafer (10) nach einem der Ansprüche 1 bis 6, aufweisend eine Dickenvariation von weniger als 10 $\mu$m, bevorzugt weniger als 5 $\mu$m, besonders bevorzugt weniger als 2 $\mu$m, ganz besonders bevorzugt weniger als 1 $\mu$m.

8. Glaswafer (10) nach einem der Ansprüche 1 bis 7, wobei die Seitenfläche (4) der Öffnung (2) einen Neigungswinkel aufweist, welcher vorzugsweise höchstens 2° ist, wobei der Neigungswinkel hier die Abweichung von einer ideal gerade verlaufenden Seitenfläche (4) ist, welche mit den Oberflächen (11, 12) des Glaswafers (10) einen Winkel von 90° bilden würde.

9. Glaswafer (10) nach einem der Ansprüche 1 bis 8, wobei die Form der Siliziummembran (61, 62) durch die darunterliegende Öffnung (2) nachgeformt ist, sodass die Form der Siliziummembran (61, 62) der Form der Öffnung (2) insofern entspricht, dass die Seitenverhältnisse von Siliziummembran (61, 62) und Öffnung (2) gleich sind.

10. Glaselement (100) für die Anwendung in Drucksensoren (6), herstellbar durch Abtrennen eines Abschnitts von einem Glaswafer (10) gemäß einem der Ansprüche 1 bis 9, wobei das Glaselement (100) ein rahmenförmiges Element mit einer Öffnung (2) ist, die einen Querschnitt mit einer Querschnittsfläche (3, 3a) aufweist, wobei die Querschnittsfläche (3, 3a) durch einen geraden Abschnitt (31), vorzugsweise mit einer Mindestlänge von mindestens 10 $\mu$m, bevorzugt mindestens 20 $\mu$m oder sogar und besonders bevorzugt mindestens 100 $\mu$m, begrenzt ist, wobei die Öffnung (2) eine Seitenfläche (4) aufweist, die eine Oberfläche (41) aufweist, welche **gekennzeichnet ist durch** eine Skewness Ssk

$$\mathrm{Ssk} = \frac{1}{S_q^3}\left[\frac{1}{A}\iint_A \left(Z(x,y)^3\right) dxdy\right]$$

von ungleich 0, wobei der Betrag der Skewness Ssk mindestens 0,001 ist und höchstens 5, wobei vorzugsweise der Betrag der Skewness mindestens 0,002, mehr bevorzugt mindestens 0,003, besonders bevorzugt mindestens 0,004 und ganz besonders bevorzugt mindestens 0,01 ist, und/oder der Betrag der Skewness höchstens 2,0, besonders bevorzugt höchstens 1,5 ist,
wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt.

11. Verfahren zur Herstellung eines Glaswafers (10) nach einem der Ansprüche 1 bis **9** oder eines Glaselements (1) nach Anspruch 10 umfassend wenigstens eine Öffnung (2), umfassend die Schritte

- Bereitstellen eines scheibenförmigen Glassubstrats (1),
- Richten eines Laserstrahls (80) eines Ultrakurzpulslasers (8) auf eine der Oberflächen (11, 12) des scheibenförmigen Glassubstrats (1), wobei der Laserstrahl (80) mittels einer Fokussierungsoptik (81) zu einem langgezogenen Fokus im scheibenförmigen Glassubstrat (1) geformt wird, sodass durch die eingestrahlte Energie des Laserstrahls (80) eine filamentförmige Schädigung (70) im Volumen des scheibenförmigen Glassubstrats (1) erzeugt wird, deren Längsrichtung senkrecht zu der Oberfläche (11, 12) des scheibenförmigen Glassubstrats (1) ist, und wobei zur Erzeugung einer filamentförmigen Schädigung (70) der Ultrakurzpulslaser (8) einen Puls oder ein Pulspaket mit mindestens zwei aufeinanderfolgenden Laserpulsen einstrahlt,
- Führen des Auftreffpunkts (82) des Laserstrahls auf dem scheibenförmigen Glassubstrat (1) entlang einer vorgegebenen geschlossenen Linie (71), sodass eine Vielzahl von nebeneinander auf der vorgegebenen Linie liegenden filamentförmigen Schädigungen (70) im scheibenförmigen Glassubstrat (1) erhalten werden, wobei vorzugsweise die Filamente (71) von einer Oberfläche (11, 12) des scheibenförmigen Glassubstrats (1) zur anderen Oberflächen (11, 12) reichen,
- Ätzen des scheibenförmigen Glassubstrats (1) zumindest in dem Bereich, in welchem filamentförmige Schädigungen (70) im scheibenförmigen Glassubstrat (1) gebildet sind, in einem flüssigen Ätzmedium, wobei die filamentförmigen Schädigungen (70) zu Kanälen aufgeweitet werden, sodass durch das Ätzen der Durchmesser der Kanäle so weit vergrößert wird und das zwischen den Kanälen befindliche glasige Material des scheibenförmigen Glassubstrats (1) abgetragen wird, sodass sich die Kanäle vereinigen und eine Öffnung (2) bilden, die einen Querschnitt mit einer Querschnittsfläche (3) aufweist, wobei die Querschnittsfläche (3) durch wenigstens eine Gerade (31) begrenzt ist, wobei die Öffnung (2) eine Seitenfläche (4) aufweist, die eine Oberfläche (41) aufweist, welche **gekennzeichnet ist durch** eine Skewness Ssk

$$\mathrm{Ssk} = \frac{1}{S_q^3}\left[\frac{1}{A}\iint_A \left(Z(x,y)^3\right) dxdy\right]$$

von ungleich 0, wobei der Betrag der Skewness Ssk mindestens 0,001 ist und höchstens 5, wobei vorzugsweise
der Betrag der Skewness mindestens 0,002, mehr bevorzugt mindestens 0,003, besonders bevorzugt mindestens 0,004 und ganz besonders bevorzugt mindestens 0,01 ist, und/oder
der Betrag der Skewness höchstens 2,0, besonders bevorzugt höchstens 1,5 ist,

- optional Vereinzeln des Glassubstrats (1) unter Erhalt eines Glaselements (100),

wobei $S_q$ die mittlere quadratische Rauigkeit der Oberfläche, beziehungsweise den RMS-Wert, bezeichnet, A die Fläche des Integrationsgebietes, für welches die Skewness bestimmt wird, Z(x,y) den jeweiligen Höhenwert des Oberflächenprofils an den Koordinaten x, y, wobei dieser Höhenwert relativ zum arithmetischen Mittelwert der Höhenwerte des Oberflächenprofils angegeben wird, und wobei der zugehörige Wert Z(x,y) positiv ist, wenn ein Punkt des Oberflächenprofils höher als der Mittelwert liegt, und negativ, wenn der Punkt unterhalb des Mittelwerts liegt.

**12.** Verfahren nach Anspruch 11, **gekennzeichnet durch** wenigstens eines der folgenden Merkmale:

- das glasige Material des scheibenförmigen Glassubstrats (1) wird mit einer Abtragsrate von kleiner als 5 μm pro Stunde abgetragen
- die Ätzdauer beträgt mindestens 12 Stunden
- der räumliche Abstand zweier Auftreffpunkte des Laserstrahls auf der wenigstens einen Oberfläche (11, 12) des scheibenförmigen Glassubstrats (1) beträgt höchstens 6 μm, vorzugsweise höchstens 4,5 μm
- die Anzahl der Pulse eines Bursts zum Einbringen einer filamentförmigen Schädigung beträgt höchstens 2 oder mindestens 7
- die Pulsdauer des Lasers liegt im Bereich von 0,5 ps bis 2 ps bei einem räumlichen Abstand zweier Auftreffpunkt des Laserstrahls auf der wenigstens einen Oberfläche (11, 12) des scheibenförmigen Glassubstrats (1) von 1 μm bis 15 μm,
- es erfolgt ein mechanisches Polieren wenigstens einer Oberfläche (11, 12).

**13.** Drucksensor (6), insbesondere piezoresistiver oder kapazitiver Drucksensor, umfassend wenigstens ein Glaselement (100) nach Anspruch 10.

**14.** Drucksensor (6) nach Anspruch 13,

wobei die Öffnung (2) des Glaselements (1) die Seitenfläche (4) der Öffnung (2) einen Neigungswinkel aufweist, welcher vorzugsweise höchstens 2° ist, wobei der Neigungswinkel hier die Abweichung von einer ideal gerade verlaufenden Seitenfläche (4) ist, welche mit den Oberflächen (11, 12) des Glaswafers (10) einen Winkel von 90° bilden würde,
umfassend eine Siliziummembran (61,62),
wobei die Öffnung (2) einen Querschnitt mit einer sich in Richtung zur Siliziummembran (61, 62) verjüngenden Querschnittsfläche (3, 3a) aufweist, sodass vorzugsweise eine vorzugsweise um mindestens 30%, bevorzugt sogar um mindestens 40% kürzere Zeit zum Erreichen des Maximaldruckes an wenigstens einem Punkt (A, B) einer vom Drucksensor (6) umfassten Siliziummembran (61, 62) als bei einer gleichbleibenden oder sich erweiterndem Querschnittsfläche (3) der Öffnung (2) erzielt werden kann,
oder
wobei die Öffnung (2) einen Querschnitt mit einer sich in Richtung zur Siliziummembran (61, 62) erweiternden Querschnittsfläche (3, 3a) aufweist, sodass vorzugsweise die Empfindlichkeit des Drucksensors (6) um wenigstens 5 %, vorzugsweise um wenigstens 10 %, gegenüber einem Drucksensor (6) mit einer gleichbleibenden oder sich erweiterndem Querschnittsfläche (3) der Öffnung (2) erhöht werden kann.

**15.** Drucksensor (6) nach einem der Ansprüche 13 oder 14, **gekennzeichnet durch** zumindest eines der folgenden Merkmale:

- eine Kavität (600) der Siliziummembran (61) weist eine Querschnittsfläche (603) auf, wobei das Verhältnis der Querschnittsfläche (603) der Kavität (600) zu der Querschnittsfläche (3, 3a) des Glaselements (100) weniger als 10, vorzugsweise weniger als 5, beträgt,
- die Siliziummembran (61) ist anodisch auf das Glaselement (100) gebondet.

**Claims**

**1.** Glass wafer (10) for producing a framelike glass element (100) for use in pressure sensors (6), more particularly piezoresistive or capacitive pressure sensors, preferably piezoresistive pressure sensors, comprising a sheetlike glass substrate (1) and also at least one opening (2) which reaches from one surface (11) of the glass substrate (1) to the other surface (12) of the glass substrate (1), the opening (2) having a cross section with a cross-sectional area (3, 3a), the cross-sectional area (3, 3a) being delimited by a straight portion (31), preferably having a minimum length of at least 10 $\mu$m, more preferably at least 20 $\mu$m or even and more particularly preferably at least 100 $\mu$m, where the opening (2) has a side face (4) having a surface (41) which is **characterized by** a skewness Ssk

$$\text{Ssk} = \frac{1}{S_q^3}\left[\frac{1}{A}\iint_A (Z(x,y)^3)\,dxdy\right]$$

of other than 0, the amount of the skewness Ssk being at least 0.001 and at most 5, where preferably
the amount of the skewness is at least 0.002, more preferably at least 0.003, very preferably at least 0.004 and especially preferably at least 0.01, and/or
the amount of the skewness is at most 2.0, more preferably at most 1.5,
where more preferably the skewness is determined in a planar region of the side face (4), preferably in a region (431) which corresponds to the straight portion (31),
where $S_q$ denotes the mean square roughness of the surface, or the RMS value, A is the area of the integration zone of which the skewness is determined, Z(x,y) is the respective height value of the surface profile at the coordinates x, y, this height value being expressed relative to the arithmetic mean of the height values of the surface profile, and where the associated value Z(x,y) is positive if a point on the surface profile is higher than the mean, and negative if the point is below the mean.

2. Glass wafer (10) according to Claim 1, wherein the cross-sectional area (3, 3a) is delimited by at least two straight portions (31), the straight portions (31) forming a corner with a radius of curvature of at least 10 $\mu$m, preferably at least 20 $\mu$m, more preferably at least 50 $\mu$m, and preferably at most 1000 $\mu$m, more preferably at most 500 $\mu$m, very preferably at most 250 $\mu$m, more preferably at most 150 $\mu$m, especially preferably at most 130 $\mu$m, most preferably at most 100 $\mu$m.

3. Glass wafer (10) according to either of Claims 1 and 2, wherein the glass substrate (1) comprises a glass having at least one of the following features:

   - the glass comprises at least 50 wt% of $SiO_2$, preferably at least 55 wt% of $SiO_2$, more preferably at least 70 wt% of $SiO_2$, especially preferably at least 78 wt% of $SiO_2$, the $SiO_2$ content of the glass being limited preferably to at most 85 wt% of $SiO_2$, more preferably to at most 83 wt% of $SiO_2$.
   - the glass comprises at least 1.5 wt% of $B_2O_3$, preferably at least 2.0 wt% of $B_2O_3$, more preferably at least 2.5 wt% of $B_2O_3$, very particularly at least 5 wt% of $B_2O_3$, the $B_2O_3$ content of the glass being limited preferably to at most 15 wt%.
   - the glass comprises at least 2 wt% of $Al_2O_3$, the $Al_2O_3$ content of the glass being limited preferably to at most 25 wt%.

4. Glass wafer (10) according to any of Claims 1 to 3, wherein the cross-sectional area (3, 3a) has a mean superficial extent of between at least 0.04 mm$^2$ and at most 2.7 mm$^2$.

5. Glass wafer (10) according to any of Claims 1 to 4, wherein the skewness is less than 0.

6. Glass wafer (10) according to any of Claims 1 to 5, **characterized by** at least one of the following features:

   - the glass wafer comprises multiple openings (2), where the land width between the openings (2) is at least 0.3 mm, preferably at least 0.5 mm, and preferably at most 7 mm, more preferably at most 5 mm.
   - the glass wafer comprises multiple openings (2), and the ratio between the openings (2) and the total surface area of the glass wafer (10) is between 0.1% and 12%, preferably between 0.2% and 10%.
   - the thickness of the glass substrate (1) is between at least 200 $\mu$m, preferably at least 300 $\mu$m, and at most 3500 $\mu$m, preferably at most 3000 $\mu$m, more preferably at most 2000 $\mu$m, especially preferably at most 180 $\mu$m, at best max. 1000 $\mu$m, to form a ratio between the thickness of the glass substrate (1) and the mean lateral dimension of the opening of between at least 0.33 and at most 3.

7. Glass wafer (10) according to any of Claims 1 to 6, having a thickness variation of less than 10 $\mu$m, preferably less than 5 $\mu$m, more preferably less than 2 $\mu$m, very preferably less than 1 $\mu$m.

8. Glass wafer (10) according to any of Claims 1 to 7, wherein the side face (4) of the opening (2) has an angle of inclination which is preferably at most 2°, the angle of inclination here being the deviation from an ideally straight-line side face (4) which would form an angle of 90° with the surfaces (11, 12) of the glass wafer (10).

9. Glass wafer (10) according to any of Claims 1 to 8, wherein the shape of the silicon membrane (61, 62) is formed according to the opening (2) beneath it, with the shape of the silicon membrane (61, 62) thus corresponding to the shape of the opening (2) insofar as the aspect ratios of silicon membrane (61, 62) and opening (2) are the same.

10. Glass element (100) for use in pressure sensors (6), producible by removing a portion from a glass wafer (10) according to any of Claims 1 to 9, wherein the glass element (100) is a framelike element having an opening (2) which has a cross section with a cross-sectional area (3, 3a), the cross-sectional area (3, 3a) being delimited by a straight portion (31), preferably having a minimum length of at least 10 $\mu$m, more preferably at least 20 $\mu$m or even and very preferably at least 100 $\mu$m, where the opening (2) has a side face (4) having a surface (41) which is **characterized by** a skewness Ssk

$$\mathrm{Ssk} = \frac{1}{S_q^3}\left[\frac{1}{A}\iint_A \left(Z(x,y)^3\right) dxdy\right]$$

of other than 0, the amount of the skewness Ssk being at least 0.001 and at most 5, where preferably the amount of the skewness is at least 0.002, more preferably at least 0.003, very preferably at least 0.004 and especially preferably at least 0.01, and/or

the amount of the skewness is at most 2.0, more preferably at most 1.5,

where $S_q$ denotes the mean square roughness of the surface, or the RMS value, A is the area of the integration zone of which the skewness is determined, Z(x,y) is the respective height value of the surface profile at the coordinates x, y, this height value being expressed relative to the arithmetic mean of the height values of the surface profile, and where the associated value Z(x,y) is positive if a point on the surface profile is higher than the mean, and negative if the point is below the mean.

11. Process for producing a glass wafer (10) according to any of Claims 1 to 9 or a glass element (1) according to Claim 10 comprising at least one opening (2), comprising the steps of:

- providing a sheetlike glass substrate (1),
- directing a laser beam (80) of an ultrashort pulse laser (8) onto one of the surfaces (11, 12) of the sheetlike glass substrate (1), where the laser beam (80) is shaped by means of focusing optics (81) into an elongated focus in the sheetlike glass substate (1), so that the irradiated energy of the laser beam (80) generates filamentary damage (70) in the volume of the sheetlike glass substrate (1) with a longitudinal direction perpendicular to the surface (11, 12) of the sheetlike glass substrate (1), and where, to generate filamentary damage (70), the ultrashort pulse laser (8) emits a pulse or a pulse package with at least two successive laser pulses,
- guiding the impingement point (82) of the laser beam on the sheetlike glass substrate (1) along a predefined continuous line (71), to give a multiplicity of filamentary damages (70) lying one beside another on the predetermined line in the sheetlike glass substrate (1), where preferably the filaments (71) reach from one surface (11, 12) of the sheetlike glass substrate (1) to the other surface (11, 12),
- etching the sheetlike glass substrate (1) at least in the region in which filamentary damages (70) are formed in the sheetlike glass substrate (1), in a liquid etching medium, where the filamentary damages (70) are widened to give channels, so that the etching enlarges the diameter of the channels to such an extent, and the vitreous material between the channels in the sheetlike glass substrate (1) is ablated, so that the channels combine and form an opening (2) which has a cross section with a cross-sectional area (3), the cross-sectional area (3) being delimited by at least one straight line (31), where the opening (2) has a side face (4) having a surface (41) which is **characterized by** a skewness Ssk

$$\mathrm{Ssk} = \frac{1}{S_q^3}\left[\frac{1}{A}\iint_A (Z(x,y)^3)\,dx\,dy\right]$$

of other than 0, the amount of the skewness Ssk being at least 0.001 and at most 5, where preferably the amount of the skewness is at least 0.002, more preferably at least 0.003, very preferably at least 0.004 and especially preferably at least 0.01, and/or
the amount of the skewness is at most 2.0, more preferably at most 1.5,

- optionally singulating the glass substrate (1) to give a glass element (100),

where $S_q$ denotes the mean square roughness of the surface, or the RMS value, A is the area of the integration zone of which the skewness is determined, Z(x,y) is the respective height value of the surface profile at the coordinates x, y, this height value being expressed relative to the arithmetic mean of the height values of the surface profile, and where the associated value Z(x,y) is positive if a point on the surface profile is higher than the mean, and negative if the point is below the mean.

12. Process according to Claim 11, **characterized by** at least one of the following features:

- the vitreous material of the sheetlike glass substrate (1) is ablated at an ablation rate of less than 5 $\mu$m per hour
- the etching time is at least 12 hours
- the spatial distance between two points of impingement of the laser beam on the at least one surface (11, 12) of the sheetlike glass substrate (1) is at most 6 $\mu$m, preferably at most 4.5 $\mu$m
- the number of pulses in a burst for introducing filamentary damage is at most 2 or at least 7

- the pulse duration of the laser is in the range from 0.5 ps to 2 ps for a spatial distance between two impingement points of the laser beam on the at least one surface (11, 12) of the sheetlike glass substrate (1) of 1 μm to 15 μm,
- at least one surface (11, 12) undergoes mechanical polishing.

**13.** Pressure sensor (6), more particularly piezoresistive or capacitive pressure sensor, comprising at least one glass element (100) according to Claim 10.

**14.** Pressure sensor (6) according to Claim 13, wherein the opening (2) of the glass element (1) the side face (4) of the opening (2) has an angle of inclination which is preferably at most 2°, the angle of inclination here being the deviation from an ideally straight-line side face (4) which would form an angle of 90° with the surfaces (11, 12) of the glass wafer (10),

comprising a silicon membrane (61,62),
where the opening (2) has a cross section with a cross-sectional area (3, 3a) that tapers in the direction of the silicon membrane (61, 62), so that preferably it is possible to achieve a preferably at least 30%, more preferably indeed at least 40%, shorter time to reach the maximum pressure at not less than one point (A, B) on a silicon membrane (61, 62) comprised by the pressure sensor (6) than in the case of a constant or expanding cross-sectional area (3) of the opening (2),
or
where the opening (2) has a cross section with a cross-sectional area (3, 3a) that expands in the direction of the silicon membrane (61, 62) so that preferably the sensitivity of the pressure sensor (6) can be increased by at least 5%, preferably by at least 10%, relative to a pressure sensor (6) having a constant or expanding cross-sectional area (3) of the opening (2).

**15.** Pressure sensor (6) according to either of Claims 13 and 14, **characterized by** at least one of the following features:

- a cavity (600) of the silicon membrane (61) has a cross-sectional area (603), where the ratio of the cross-sectional area (603) of the cavity (600) to the cross-sectional area (3, 3a) of the glass element (100) is less than 10, preferably less than 5,
- the silicon membrane (61) is bonded anodically on the glass element (100).

**Revendications**

**1.** Tranche de verre (10) destinée à la fabrication d'un élément en verre (100) en forme de cadre pour l'utilisation dans des capteurs de pression (6), en particulier des capteurs de pression piézorésistifs ou capacitifs, de préférence des capteurs de pression piézorésistifs, comprenant un substrat en verre (1) en forme de disque ainsi qu'au moins une ouverture (2) qui s'étend d'une surface (11) du substrat en verre (1) à l'autre surface (12) du substrat en verre (1), l'ouverture (2) présentant une section transversale ayant une face (3, 3a) de section transversale, la face (3, 3a) de section transversale étant délimitée par un segment rectiligne (31), de préférence ayant une longueur minimale d'au moins 10 μm, de préférence d'au moins 20 μm ou même et de façon particulièrement préférée d'au moins 100 μm, l'ouverture (2) présentant une face latérale (4) qui présente une surface (41) qui est **caractérisée par** un coefficient d'asymétrie Ssk

$$\mathrm{Ssk} = \frac{1}{S_q^3} \left[ \frac{1}{A} \iint_A \left( Z(x,y)^3 \right) dx dy \right]$$

différent de 0, la valeur du coefficient d'asymétrie Ssk étant au moins 0,001 et au maximum 5, de préférence la valeur du coefficient d'asymétrie étant au moins 0,002, plus préférablement au moins 0,003, de façon particulièrement préférée au moins 0,004 et de façon tout particulièrement préférée au moins 0,01, et/ou la valeur du coefficient d'asymétrie étant au maximum 2,0, de façon particulièrement préférée au maximum 1,5, de façon particulièrement préférée le coefficient d'asymétrie étant déterminé dans une zone plane de la face latérale (4), de préférence dans une zone (431) qui correspond au segment rectiligne (31).
Sq désignant la rugosité quadratique moyenne de la surface, c'est-à-dire la valeur RMS, A la surface de la zone d'intégration pour laquelle le coefficient d'asymétrie est déterminé, Z(x,y) la valeur de hauteur respective du profil de surface au niveau des coordonnées x, y, cette valeur de hauteur étant indiquée par rapport à la valeur moyenne arithmétique des valeurs de hauteur du profil de surface, et la valeur correspondante Z(x,y) étant positive si un point du profil de surface se trouve au-dessus de la moyenne, et négative si le point se trouve au-dessous de la moyenne.

2. Tranche de verre (10) selon la revendication 1, dans laquelle la face (3, 3a) de section transversale est délimitée par au moins deux segments rectilignes (31), lesdits segments rectilignes (31) formant un coin ayant un rayon de courbure d'au moins 10 $\mu$m, de préférence d'au moins 20 $\mu$m, de façon particulièrement préférée d'au moins 50 $\mu$m, et de préférence d'au maximum 1 000 $\mu$m, de préférence d'au maximum 500 $\mu$m, de façon particulièrement préférée d'au maximum 250 $\mu$m, plus préférablement d'au maximum 150 $\mu$m, de façon tout particulièrement préférée d'au maximum 130 $\mu$m, de façon la plus particulièrement préférée d'au maximum 100 $\mu$m.

3. Tranche de verre (10) selon l'une quelconque des revendications 1 et 2, dans laquelle le substrat en verre (1) comporte un verre ayant au moins l'une des caractéristiques suivantes :

- le verre comprend au moins 50 % en poids de $SiO_2$, de préférence au moins 55 % en poids de $SiO_2$, de façon particulièrement préférée au moins 70 % en poids de $SiO_2$, de façon tout particulièrement préférée au moins 78 % en poids de $SiO_2$, la teneur du verre en $SiO_2$ étant de préférence limitée à au maximum 85 % en poids de $SiO_2$, de préférence à au maximum 83 % en poids de $SiO_2$.
- le verre comprend au moins 1,5 % en poids de $B_2O_3$, de préférence au moins 2,0 % en poids de $B_2O_3$, de façon particulièrement préférée au moins 2,5 % en poids de $B_2O_3$, de façon tout particulièrement préférée au moins 5 % en poids de $B_2O_3$, la teneur du verre en $B_2O_3$ étant de préférence limitée à au maximum 15 % en poids.
- le verre comprend au moins 2 % en poids d'$Al_2O_3$, la teneur du verre en $Al_2O_3$ étant de préférence limitée à au maximum 25 % en poids.

4. Tranche de verre (10) selon l'une quelconque des revendications 1 à 3, dans laquelle la face (3, 3a) de section transversale présente une superficie moyenne comprise entre au moins 0,04 mm$^2$ et au maximum 2,7 mm$^2$.

5. Tranche de verre (10) selon l'une quelconque des revendications 1 à 4, dans laquelle le coefficient d'asymétrie est inférieur à 0.

6. Tranche de verre (10) selon l'une quelconque des revendications 1 à 5, **caractérisée par** au moins l'une des caractéristiques suivantes :

- la tranche de verre comprend plusieurs ouvertures (2), la largeur de traverse entre les ouvertures (2) étant d'au moins 0,3 mm, de préférence d'au moins 0,5 mm et de préférence d'au maximum 7 mm, de préférence d'au maximum 5 mm.
- la tranche de verre comprend plusieurs ouvertures (2), et le rapport entre les ouvertures (2) et la surface totale de la tranche de verre (10) se situe entre 0,1 % et 12 %, de préférence entre 0,2 % et 10 %.
- l'épaisseur du substrat en verre (1) se situe entre au moins 200 $\mu$m, de préférence au moins 300 $\mu$m, et au maximum 3 500 $\mu$m, de préférence au maximum 3 000 $\mu$m, de façon particulièrement préférée au maximum 2 000 $\mu$m, de façon tout particulièrement préférée au maximum 180 $\mu$m, au mieux au maximum 1 000 $\mu$m, de sorte qu'entre l'épaisseur du substrat en verre (1) et la dimension latérale moyenne de l'ouverture est établi un rapport entre au moins 0,33 et au maximum 3.

7. Tranche de verre (10) selon l'une quelconque des revendications 1 à 6, présentant une variation d'épaisseur de moins de 10 $\mu$m, de préférence de moins de 5 $\mu$m, de façon particulièrement préférée de moins de 2 $\mu$m, de façon particulièrement préférée de moins de 1 $\mu$m.

8. Tranche de verre (10) selon l'une quelconque des revendications 1 à 7, dans laquelle la face latérale (4) de l'ouverture (2) présente un angle d'inclinaison qui est de préférence d'au maximum 2°, l'angle d'inclinaison étant ici l'écart par rapport à une face latérale (4), s'étendant de façon idéalement rectiligne, qui formerait un angle de 90° avec les surfaces (11, 12) de la tranche de verre (10).

9. Tranche de verre (10) selon l'une quelconque des revendications 1 à 8, dans laquelle la forme de la membrane en silicium (61, 62) est reproduite par l'ouverture (2) sous-jacente, de sorte que la forme de la membrane en silicium (61, 62) correspond à la forme de l'ouverture (2) dans la mesure où les rapports des côtés de la membrane en silicium (61, 62) et de l'ouverture (2) sont identiques.

**10.** Élément en verre (100) pour l'utilisation dans des capteurs de pression (6), pouvant être produit par séparation d'une partie d'une tranche de verre (10) selon l'une quelconque des revendications 1 à 9, l'élément en verre (100) étant un élément en verre en forme de cadre comportant une ouverture (2) qui présente une section transversale ayant une face (3, 3a) de section transversale, la face (3, 3a) de section transversale étant délimitée par un segment rectiligne (31), de préférence ayant une longueur minimale d'au moins 10 μm, de préférence d'au moins 20 μm ou même et de façon particulièrement préférée d'au moins 100 μm, l'ouverture (2) présentant une face latérale (4) qui présente une surface (41) qui est **caractérisée par** un coefficient d'asymétrie Ssk

$$\mathrm{Ssk} = \frac{1}{S_q^3} \left[ \frac{1}{A} \iint_A \left( Z(x,y)^3 \right) dxdy \right]$$

différent de 0, la valeur du coefficient d'asymétrie Ssk étant au moins 0,001 et au maximum 5, de préférence la valeur du coefficient d'asymétrie étant au moins 0,002, plus préférablement au moins 0,003, de façon particulièrement préférée au moins 0,004 et de façon tout particulièrement préférée au moins 0,01, et/ou la valeur du coefficient d'asymétrie étant au maximum 2,0, de façon particulièrement préférée au maximum 1,5, Sq désignant la rugosité quadratique moyenne de la surface, c'est-à-dire la valeur RMS, A la surface de la zone d'intégration pour laquelle le coefficient d'asymétrie est déterminé, Z(x,y) la valeur de hauteur respective du profil de surface au niveau des coordonnées x, y, cette valeur de hauteur étant indiquée par rapport à la valeur moyenne arithmétique des valeurs de hauteur du profil de surface, et la valeur correspondante Z(x,y) étant positive si un point du profil de surface se trouve au-dessus de la moyenne, et négative si le point se trouve au-dessous de la moyenne.

**11.** Procédé de fabrication d'une tranche de verre (10) selon l'une quelconque des revendications 1 à 9 ou d'un élément en verre (1) selon la revendication 10, comprenant au moins une ouverture (2), comprenant les étapes

- mise à disposition d'un substrat en verre en forme de disque (1),
- orientation d'un faisceau laser (80) d'un laser à impulsions ultracourtes (8) sur l'une des surfaces (11, 12) du substrat en verre (1) en forme de disque, le faisceau laser (80) étant configuré au moyen d'une optique de focalisation (81) en un foyer allongé dans le substrat en verre (1) en forme de disque, de sorte que par l'énergie incidente du faisceau laser (80) une altération (70) en forme de filament est produite dans le volume du substrat en verre (1) en forme de disque, dont la direction longitudinale est perpendiculaire à la surface (11, 12) du substrat en verre (1) en forme de disque, et pour la production d'une altération (70) en forme de filament, le laser à impulsions ultracourtes (8) émet une impulsion ou un paquet d'impulsions comportant au moins deux impulsions laser successives,
- guidage du point d'impact (82) du faisceau laser sur le substrat en verre (1) en forme de disque le long d'une ligne fermée (71) préétablie, de manière à obtenir dans le substrat en verre (1) en forme de disque une pluralité d'altérations (70) en forme de filaments, juxtaposées sur la ligne préétablie, de préférence les filaments (71) s'étendant depuis une surface (11, 12) du substrat en verre (1) en forme de disque jusqu'à l'autre surface (11, 12),
- attaque chimique du substrat de verre (1) en forme de disque au moins dans la zone dans laquelle des altérations (70) en forme de filaments sont formées dans le substrat en verre (1) en forme de disque, dans un milieu liquide d'attaque chimique, les altérations (70) en forme de filaments étant élargies en canaux, de sorte que le diamètre des canaux est augmenté suffisamment par l'attaque chimique et la matière vitreuse du substrat de verre (1) en forme de disque qui se trouve entre les canaux est enlevée, de sorte que les canaux se réunissent et forment une ouverture (2) qui présente une section transversale ayant une face (3) de section transversale, la face (3) de section transversale étant délimitée par au moins une droite (31), l'ouverture (2) présentant une face latérale (4) qui présente une surface (41) qui est **caractérisée par** un coefficient d'asymétrie Ssk

$$\mathrm{Ssk} = \frac{1}{S_q^3} \left[ \frac{1}{A} \iint_A \left( Z(x,y)^3 \right) dxdy \right]$$

différent de 0, la valeur du coefficient d'asymétrie Ssk étant au moins 0,001 et au maximum 5, de préférence

la valeur du coefficient d'asymétrie étant au moins 0,002, plus préférablement au moins 0,003, de façon particulièrement préférée au moins 0,004 et de façon tout particulièrement préférée au moins 0,01, et/ou la valeur du coefficient d'asymétrie étant au maximum 2,0, de façon particulièrement préférée au maximum 1,5,

- en option division du substrat en verre (1) avec obtention d'un élément en verre (100),

Sq désignant la rugosité quadratique moyenne de la surface, c'est-à-dire la valeur RMS, A la surface de la zone d'intégration pour laquelle le coefficient d'asymétrie est déterminé, Z(x,y) la valeur de hauteur respective du profil de surface au niveau des coordonnées x, y, cette valeur de hauteur étant indiquée par rapport à la valeur moyenne arithmétique des valeurs de hauteur du profil de surface, et la valeur correspondante Z(x,y) étant positive si un point du profil de surface se trouve au-dessus de la moyenne, et négative si le point se trouve au-dessous de la moyenne.

12. Procédé selon la revendication 11, **caractérisé par** au moins l'une des caractéristiques suivantes :

- la matière vitreuse du substrat en verre (1) en forme de disque est enlevée à une vitesse d'enlèvement de moins de 5 $\mu$m par heure
- la durée de l'attaque chimique est d'au moins 12 heures
- la distance spatiale entre deux points d'impact du faisceau laser sur ladite au moins une surface (11, 12) du substrat en verre (1) en forme de disque est au maximum de 6 $\mu$m, de préférence au maximum de 4,5 $\mu$m
- le nombre des impulsions d'une rafale pour l'introduction d'une altération en forme de filament est au maximum de 2 ou au moins 7
- la durée d'impulsion du laser se situe dans la plage de 0,5 ps à 2 ps pour une distance spatiale de deux points d'impact du faisceau laser sur ladite au moins une surface (11, 12) du substrat en verre (1) en forme de disque de 1 $\mu$m à 15 $\mu$m,
- il s'effectue un polissage mécanique d'au moins une surface (11, 12).

13. Capteur de pression (6), en particulier capteur de pression piézorésistif ou capacitif, comprenant au moins un élément en verre (100) selon la revendication 10.

14. Capteur de pression (6) selon la revendication 13, dans lequel l'ouverture (2) de l'élément en verre (1), la surface latérale (4) de l'ouverture (2) présente un angle d'inclinaison qui est de préférence d'au maximum 2°, l'angle d'inclinaison étant ici l'écart par rapport à une face latérale (4), s'étendant de façon idéalement rectiligne, qui formerait un angle de 90° avec les surfaces (11, 12) de la tranche de verre (10).

comprenant une membrane en silicium (61, 62),
dans lequel l'ouverture (2) présente une section transversale comportant une face (3, 3a) de section transversale se rétrécissant en direction de la membrane en silicium (61, 62), de sorte que de préférence peut être obtenu un temps plus court d'au moins 30 %, de préférence même d'au moins 40 %, pour atteindre la pression maximale en au moins un point (A, B) d'une membrane en silicium (61, 62) entourée par le capteur de pression (6) qu'avec une face (3) de section transversale de l'ouverture (2) restant constante ou s'élargissant,
ou
dans lequel l'ouverture (2) présente une section transversale comportant une face (3, 3a) de section transversale s'élargissant en direction de la membrane en silicium (61, 62), de sorte que de préférence la sensibilité du capteur de pression (6) peut être augmentée d'au moins 5 %, de préférence d'au moins 10 %, par rapport à un capteur de pression (6) présentant une face (3) de section transversale de l'ouverture (2) restant constante ou s'élargissant.

15. Capteur de pression (6) selon l'une quelconque des revendications 13 et 14, **caractérisé par** au moins l'une des caractéristiques suivantes :

- une cavité (600) de la membrane de silicium (61) présente une face (603) de section transversale, le rapport de la surface (603) de section transversale de la cavité (600) à la surface (3, 3a) de section transversale de l'élément en verre (100) étant inférieur à 10, de préférence inférieur à 5,
- la membrane en silicium (61) est liée par anodisation à l'élément en verre (100).

10

1

2

31

3

32

Fig. 1

10

2

1

31

32

3

Fig. 2

Fig. 3

Fig. 4

11

110

5

4

51

52

12

**Fig. 5**

610

6

601

62

61

100

60

63

600

2

**Fig. 6**

8

80

81

1

82

70

9

Fig. 7

91

71

1

70

Fig. 8

Fig. 9

Fig. 10

Fig. 11

Fig. 12

Ansicht von oben

Ansicht von unten

Fig. 13

Vergleich axialsymmetrisches Modell und abgerundet-quadratisches 3D-Modell: Punkt A

Vergleich axialsymmetrisches Modell und abgerundet-quadratisches 3D-Modell: Punkt B

Fig. 14

a)

b)

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP S57128074 A
- US 20110000304 A1
- US 20060288793 A1
- US 20050172724 A1
- JP H09126924 A
- US 9470593 B2
- US 20090096040 A1